(19) Europäisches Patentamt
European Patent Office
Office européen des brevets

(11) EP 1 866 985 B1

(12) **EUROPEAN PATENT SPECIFICATION**

(45) Date of publication and mention of the grant of the patent:
**17.09.2014 Bulletin 2014/38**

(21) Application number: **06842827.5**

(22) Date of filing: **08.12.2006**

(51) Int Cl.:
***H01L 51/50*** *(2006.01)* ***C09K 11/06*** *(2006.01)*

(86) International application number:
**PCT/JP2006/324996**

(87) International publication number:
**WO 2007/072741 (28.06.2007 Gazette 2007/26)**

(54) **ORGANIC LIGHT-EMITTING DEVICE**

ORGANISCHE LICHTEMITTIERENDE VORRICHTUNG

DISPOSITIF ELECTROLUMINESCENT ORGANIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **20.12.2005 JP 2005366556**
**28.04.2006 JP 2006125013**
**12.10.2006 JP 2006278925**

(43) Date of publication of application:
**19.12.2007 Bulletin 2007/51**

(73) Proprietor: **CANON KABUSHIKI KAISHA**
**Tokyo (JP)**

(72) Inventors:
- **OKINAKA, Keiji, CANON KABUSHIKI KAISHA Tokyo 146-8501 (JP)**
- **YAMADA, Naoki, CANON KABUSHIKI KAISHA Tokyo 146-8501 (JP)**
- **IGAWA, Satoshi, CANON KABUSHIKI KAISHA Tokyo 146-8501 (JP)**
- **KAMATANI, Jun, CANON KABUSHIKI KAISHA Tokyo 146-8501 (JP)**
- **YASHIMA, Masataka, CANON KABUSHIKI KAISHA Tokyo 146-8501 (JP)**

(74) Representative: **TBK**
**Bavariaring 4-6**
**80336 München (DE)**

(56) References cited:
**EP-A1- 1 565 041**
**WO-A1-2005/081587**
**WO-A2-2005/026088**
**JP-A- 2004 043 349**
**JP-A- 2004 221 045**
**JP-A- 2005 068 087**
**JP-A- 2006 156 888**
**JP-A- 2007 015 961**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 866 985 B1

## Description

TECHNICAL FIELD

The present invention relates to a light-emitting device using an organic compound, and more specifically, to an organic light-emitting device that emits light by applying an electric field to a thin film composed of an organic compound.

BACKGROUND ART

An organic light-emitting device includes a thin film containing a luminescent organic compound which is interposed between an anode and a cathode. In the device, holes and electrons are injected from the respective electrodes to generate excitons of the luminescent organic compound and then light is irradiated when the excitons return to its ground state. The device utilizes the light to be radiated.

Appl. Phys. Lett. 51, 913 (1987) reports a separated-function device constituted of two layers. The device uses ITO in its anode, uses an alloy of magnesium and silver in its cathode, uses an aluminum quinolinol complex as an electron transport material and a light-emitting material, and uses a triphenylamine derivative as a hole transport material. In addition, the document reports that the device emits light having a luminance of about 1,000 cd/m$^2$ at an applied voltage of about 10 V.

In addition, an organic phosphorescent-light-emitting device using an iridium complex such as Ir(ppy)$_3$ as a light-emitting material has been recently attracting attention and reported to have a high emission efficiency (Appl. Phys. Lett. 75, 4 (1999)).

An organic light-emitting device has recently showed significant progress. The device suggests its potential to find use in a wide variety of applications because of its characteristics such as the fact that the device can be produced into a thin light-weight light-emitting device which shows high luminance at a low applied voltage, has a variety of emission wavelengths and provides high-speed response.

However, particularly in a case where it is assumed that a current organic light-emitting device is applied to, for example, a full-color display, the emission efficiency and stability of the device are not sufficient for the device to be put into practical use. In particular, an additional improvement in performance of a blue-light-emitting device has been needed.

Regarding an improvement in stability of a blue-light-emitting device, Japanese Patent Application Laid-Open No. 2005-108726 discloses a device characterized in that a light-emitting layer contains an electron movable material, a hole movable material as an assist dopant, and a luminescent dopant.

For example, Japanese Patent Application Laid-Open No. H10-189248 discloses a device containing a fluoranthene skeleton material.

For example, SOGIETY FOR INFORMATION DISPLAY 2003 INTERNATIONAL SYMPOSIUM, DIGEST OF TECHNICAL PAPERS, 45. 3, 1294 (2003) discloses a device containing.a pyrene s.keleton material.

WO 2005081587 (A1) relates to a white color organic electroluminescence device comprising a negative electrode and a positive electrode and, interposed therebetween, one or more organic thin film layers including at least a light emitting layer, wherein the light emitting layer is constituted of a laminate of blue color light emitting layer and yellow-to-red color light emitting layer and contains an asymmetric condensed-ring-containing compound.

EP 1565041 (A1) relates to an organic electroluminescence element comprising: an anode; a first emitting layer comprising at least a first host material and a first dopant; a second emitting layer comprising at least a second host material and a second dopant; and a cathode in the order mentioned: wherein the energy gap Egh1 of the first host material, the energy gap Egd1 of the first dopant, the energy gap Egh2 of the second host material, and the energy gap Egd2 of the second dopant satisfy the following formulas; and the luminescent intensity I1 at the maximum luminescent wavelength of an emission spectrum derived from the first emitting layer, and the luminescent intensity I2 at the maximum luminescent wavelength of an emission spectrum derived from the second emitting layer satisfy the following formula:

$$Egh1 > Egd1$$

$$Egh2 > Egd2$$

$$Egd1 > Egd2$$

I1 > 3.5 x I2. </DF>

DISCLOSURE OF THE INVENTION

An object of the present invention is to provide a blue-light-emitting device having a high emission efficiency and a long continuous driving lifetime.

The inventors of the present invention have made extensive studies with a view to solving the above-mentioned problems. As a result, they have accomplished the present invention.

That is, the present invention provides.an organic light-emitting device according to claim 1. Further beneficial developments are set forth in the dependent claims.

According to the present invention, there can be provided a blue-light-emitting device having a high emission efficiency and a long continuous driving lifetime.

Further features of the present invention will become apparent from the following description of exemplary embodiments with reference to the attached drawings.

BRIEF DESCRIPTION OF THE DRAWINGS.

FIG. 1 is a sectional view showing an example of an organic light-emitting device of the present invention;
FIG. 2 is a sectional .view showing another example of the organic light-emitting device of the present invention;
FIG. 3 is a sectional view showing still another example of the organic light-emitting device of the present invention; and
FIG. 4 is a sectional view showing further example of the organic light-emitting device of the present invention.

BEST MODE FOR CARRYING OUT THE INVENTION

FIGS. 1 to 4 each show examples of the constitution of an organic light-emitting device of the present invention.

FIG. 1 shows a constitution obtained by sequentially providing, on a substrate 1, an anode 2, a hole transport layer 5, an electron transport layer 6, and a cathode 4. In this case, one of the hole transport layer and the electron transport layer serves as a light-emitting layer.

FIG. 2 shows a constitution obtained by sequentially providing, on the substrate 1, the anode 2, the hole transport layer 5, a light-emitting layer 3, the electron transport layer 6, and the cathode 4. In this constitution, a carrier transport function and a light-emitting function are separated from each other, and a region in which a hole and an electron recombine with each other is present in the light-emitting layer. The constitution is suitably used in combination with compounds having respective properties, that is, hole transport property, electron transport property, and light-emitting property, so the degree of freedom in the selection of materials extremely increases. In addition, the variety of emission hues can be increased because various compounds different in emission wavelength from each other can be used. Further, emission efficiency can be improved by effectively confining each carrier or each exciton in the light-emitting layer 3 as a central layer.

FIG. 3 shows a constitution different from that shown in FIG. 2 in that a hole injection layer 7 as one kind of a hole transport layer is inserted on a side of the anode 2 and has an improving effect on adhesiveness between the anode 2 and the hole transport layer 5 or on hole injection property, and is effective for a reduced voltage at which the device is driven.

FIG. 4 shows a constitution different from that shown in FIG. 2 in that a hole block layer 8 as one kind of an electron transport layer is provided between the light-emitting layer 3 and the electron transport layer 6. This constitution includes a compound having a large ionization potential (that is, a low HOMO energy) in the hole block layer 8 to alleviate the leak of a hole from the light-emitting layer toward a cathode side, and is effective for an improvement in emission efficiency.

In the present invention, the light-emitting region includes a compound having a pyrene skeleton as a host material. The examples of the compound having a pyrene skeleton includes, but not limited to, the following materials.

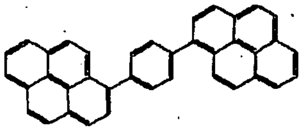
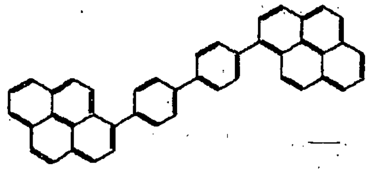
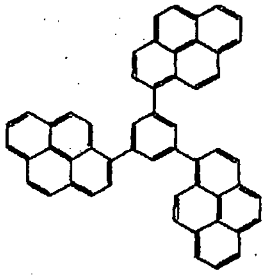

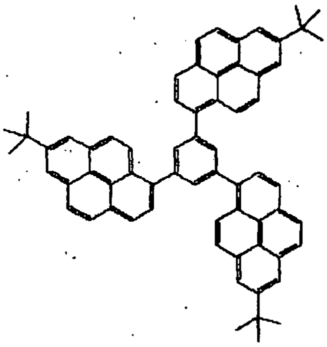
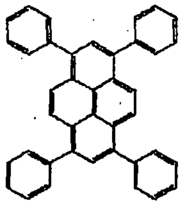
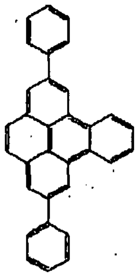
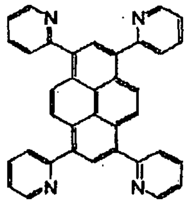

A pyrene skeleton material according to the present invention is particularly excellent in electron transport property (that is, the material has a large electron mobility and a smaller hole mobility as compared to the electron mobility). In particular, a material having a high electron mobility of $1 \times 10^{-4}$ $cm^2/Vs$ or more can be easily obtained. Therefore, when a light-emitting layer is formed of the material, a device can be driven at a low voltage, so that power efficiency can be improved. In this case, however, there has been a tendency that carrier balance between electrons and holes in the light-emitting layer is disturbed or that a light-emitting region is extremely deviated to the interface of the light-emitting layer on an anode side. Accordingly, a reduction in emission efficiency of the device, or the deterioration of the device due to continuous driving became in some cases.

In addition, a pyrene skeleton material can be used also as a light-emitting material for a blue color region. However, the material generally tends to show the large broadening of an emission spectrum due to molecular aggregation, so that the material has been disadvantageous for obtaining pure blue-light emission.

To alleviate the above-mentioned various problems, in the present invention, the light-emitting layer is doped with a compound having a fluoranthene skeleton as a luminescent dopant. Further, a lowest unoccupied molecular orbital (LUMO) energy EL1 of the luminescent dopant material and a lowest unoccupied molecular orbital energy EL2 of the host material satisfy the relationship of $EL2 - EL1 \geq 0.15$ eV. Here, the lowest unoccupied molecular orbital energy of an ordinary molecule has a negative value.

Since the lowest unoccupied molecular orbitals involved in electron transport satisfy the above-mentioned relationship, the luminescent dopant functions as an electron trap, so that the electron transport performance of the light-emitting layer becomes lower than that of the host material alone.

That is, the electron mobility of the light-emitting layer becomes smaller than that of the host material alone. As a result, the disturbance of a carrier balance and the extreme deviation of the light-emitting region are alleviated. It is desirable that the electron mobility of the light-emitting layer be reduced by one or more orders of magnitude owing to the electron trap. That is, an electron mobility $\mu E$ of the light-emitting layer and an electron mobility $\mu H$ of the host material alone desirably satisfy the relationship of $\mu E/\mu H \leq 0.1$.

According to the investigation based on carrier mobility measurement conducted by the inventors of the present invention, a sufficient electron trap effect cannot be obtained when the relationship of $EL2 - EL1 < 0.15$ eV is established.

In addition, a highest occupied molecular orbital (HOMO) energy EHH of the host material and a highest occupied molecular orbital energy EHD of the luminescent dopant material satisfy the relationship of $EHH - EHD > 0$ eV. Here, the highest occupied molecular orbital energy of an ordinary molecule has a negative value. A hole in the light-emitting layer is not trapped in the luminescent dopant, so hat the hole transport performance of the light-emitting

layer does not largely differ from that of the host material alone.

In contrast, when a hole is trapped in the luminescent dopant, the hole transport performance of the light-emitting layer becomes lower than that of the host material alone, so that balance between electrons and holes is additionally disturbed.

According to the present invention, the deviation of the light-emitting region in the light-emitting layer is alleviated on the basis of such principle as described above, whereby the light emitting region expands in the light-emitting layer. The fact means that a part of electrons injected into the light-emitting layer reach the interface of the light-emitting layer on an anode side while part of holes reach the interface of the light-emitting layer on a cathode side. Therefore, the organic light-emitting device of the present invention has a particularly preferably structure in which a hole transport layer is arranged on the anode side of the light emitting layer, and an electron transport layer is arranged on the cathode side of the light-emitting layer so that the layers can confine an electron and a hole in the light-emitting layer.

Even in a case of a light-emitting layer emitting blue light, the energy gap of a hole transport material constituting a hole transport layer in contact with the light-emitting layer is preferably larger than 3.15 eV in order that an electron and a hole may be effectively confined. In addition, the energy gap of an electron transport material constituting an electron transport layer in contact with the light-emitting layer is preferably larger than 3.00 eV.

In addition, when a material having a fluoranthene skeleton is used as a luminescent dopant, blue light having a spectral bandwidth narrower than that of a host material having a pyrene skeleton can be easily emitted.

Examples of a luminescent dopant having a fluoranthene skeleton include, but not limited to, the following materials.

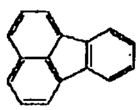
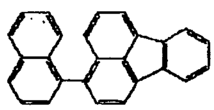
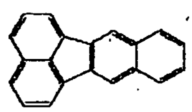
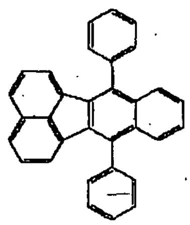
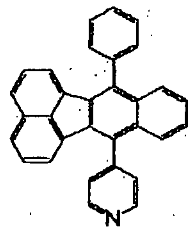

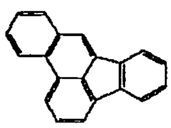
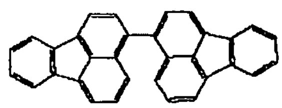
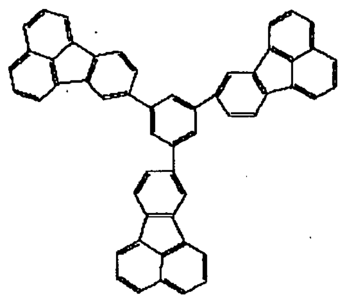
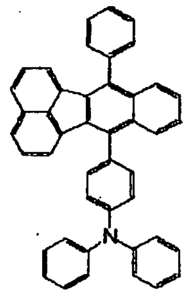

The host material preferably has a fluorene skeleton in addition to the pyrene skeleton. The host material particularly preferably has any one of the structures represented by the following general formulae (1) to (3):

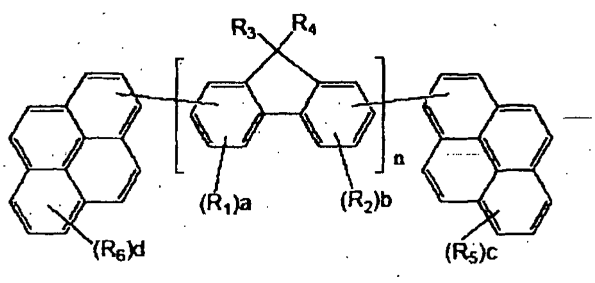
(1)

wherein $R_1$ and $R_2$ groups each represent a hydrogen atom, a substituted or unsubstituted alkyl group, a substituted or unsubstituted aralkyl group, a substituted or unsubstituted aryl group, a substituted or unsubstituted heterocyclic

group, a substituted amino group, a cyano group, or a halogen atom; $R_i$ groups bonded to.different fluorenediyl groups or $R_2$ groups bonded to different fluorenediyl groups may be the same or different, and $R_1$ groups bonded to the same fluorenediyl group, $R_2$ groups bonded to the same fluorenediyl group, or $R_1$ and $R_2$ groups bonded to the same fluorenediyl group may be the same or different;

$R_3$ and $R_4$ groups each represent a hydrogen atom, a substituted or unsubstituted alkyl group, a substituted or unsubstituted aralkyl group, a substituted or unsubstituted aryl group, or a substituted or unsubstituted heterocyclic group; $R_3$ groups bonded to different fluorenediyl groups, or $R_4$ groups bonded to different fluorenediyl groups may be the same or different, and $R_3$ and $R_4$ groups bonded to the same fluorenediyl group may be the same or different;

$R_5$ and $R_6$ groups each represent a hydrogen atom, a substituted or unsubstituted alkyl group, a substituted or unsubstituted aralkyl group, a substituted or unsubstituted aryl group, a substituted or unsubstituted heterocyclic group, a substituted amino group, a cyano group, or a halogen atom; $R_5$ groups, $R_6$ groups, or $R_5$ and $R_6$ groups may be the same or different; and

a and b each represent an integer of 1 to 3 and may be the same or different, c and d each represent an integer of 1 to 9 and may be the same or different, and n represents an integer of 1 to 10;

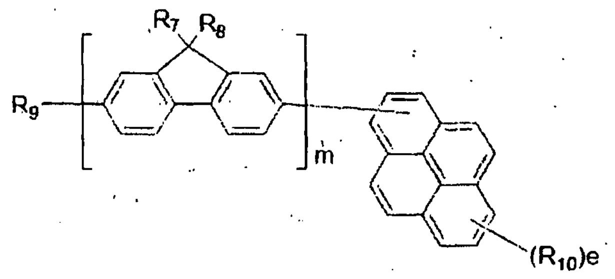

(2)

wherein $R_7$ groups and $R_8$ groups each represent a hydrogen atom, a substituted or unsubstituted alkyl group, a substituted or unsubstituted aralkyl group, a substituted or unsubstituted aryl group, or a substituted or unsubstituted heterocyclic group, and $R_7$ groups and $R_8$ groups may be the same or different;

$R_9$ group represents a hydrogen atom, a linear, branched, or cyclic alkyl group (one or more methylene groups of the alkyl group may be substituted by -O-, -S-, -CO-, -CO-O-, -O-CO-, CH=CH-, -C≡C-, an arylene group that may have a substituent, or a heterocyclic group that may have a substituent, and a hydrogen atom in the alkyl group may be substituted by a fluorine atom) or a substituted or unsubstituted aryl group which has 2 or less rings (one or more CH groups of the aryl group may be substituted by an N atom;

$R_{10}$ group represents a hydrogen atom, a substituted or unsubstituted alkyl group, a substituted or unsubstituted aralkyl group, a substituted or unsubstituted aryl group, a substituted or unsubstituted heterocyclic group, a substituted amino group, or a halogen atom;

e represents an integer of 1 to 9, and when a plurality of $R_{10}$ groups are present, the plurality of $R_{10}$ groups may be the same or different; and

m represents an integer of 2 to 10, and a plurality of fluorenediyl groups may be the same or different; and

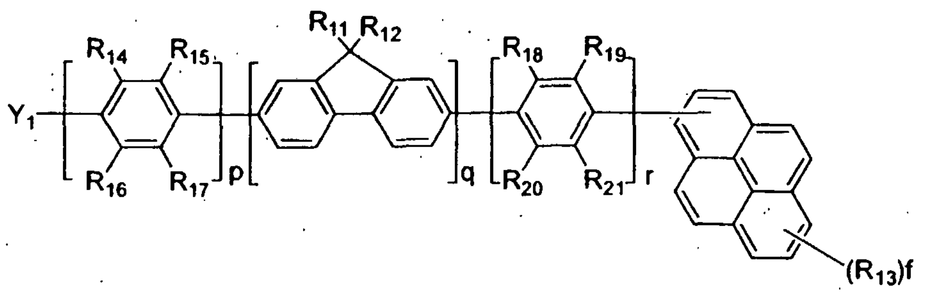

(3)

wherein $R_{11}$ and $R_{12}$, and $R_{19}$ to $R_{21}$ groups each represent a hydrogen atom, a substituted or unsubstituted alkyl group, a substituted or unsubstituted aralkyl group, a substituted or unsubstituted aryl group, or a substituted or unsubstituted heterocyclic group, and $R_{11}$ and $R_{12}$ groups may be the same or different;

$Y_1$ group represents a hydrogen atom or a substituted or unsubstituted fused ring structure composed of hydrocarbon;

q represents an integer of 1 to 10, and when q represents 2 or more, a plurality of fluorenediyl groups may be the same or different;

p means a number of a repeating structure of substituted or unsubstituted phenyl groups, and represents zero or an integer of 1 to 20;

r means a number of a repeating structure of substituted or unsubstituted phenyl groups, and represents an integer of 1 to 20; and

$R_{13}$ group represents a hydrogen atom, a substituted or unsubstituted alkyl group, a substituted or unsubstituted aralkyl group, a substituted or unsubstituted aryl group, a substituted or unsubstituted heterocyclic group, a substituted amino group, or a halogen atom, f represents an integer of 1 to 9, and when a plurality of $R_{13}$ groups are present, the plurality of $R_{13}$ groups may be the same or different.

In the formulae (1) to (3), examples of an alkyl group include a methyl group, an ethyl group, a normal propyl group, an isopropy group, a normal butyl group, a teriary butyl group, a secondary butyl group, an octyl group, a 1-adamantyl group, and a 2-adamantyl group.

Examples of an aralkyl group include a benzyl group and a phenethyl group.

Examples of an aryl group include a phenyl group, a naphthyl group, a pentalenyl group, an indenyl group, an azulenyl group, an anthryl group, a pyrenyl group, an indacenyl group, an acenaphthenyl group, a phenanthryl group, a phenalenyl group, a fluroranthenyl group, an acephenanthryl group, an aceanthryl group, a triphenylenyl group, a chrysenyl group, a naphthacenyl group, a perylenyl group, a pentacenyl group, a biphenyl group, a terphenyl group, and a fluolenyl group.

Examples of a heterocyclic group include a thienyl group, a pyrrolyl group, a pyridyl group, an oxazolyl group, an oxadiazolyl group, a thiazolyl group, a thiadiazolyl group, a terthienyl group, a carbazolyl group, an acridinyl group, and a phenanthrolyl group.

Examples of a substituted amino group include a dimethylamino group, a diethylamino group, a dibenzylamino group, diphenylamino group, a ditolylamino group, and a dianisolylamino group.

Examples of a halogen atom include fluorine, chlorine, bromine, and iodine.

Examples of a substituent which the above-mentioned subtituents each may have include an alkyl group such as a methyl group, an ethyl group, or a propyl group; an aralkyl group such as a benzyl group or a phenethyl group; an aryl group such as a phenyl group or biphenyl group; a heterocyclic group such as a thienyl group, a pyrrolyl group, or a pyridyl group; an amino group such as a dimethylamino group, a diethylamino group, a dibenzylamino group, a diphenylamino group, a ditolylamino group, or a dianisolylamino group;,an alkoxyl group such as a methoxyl group, an ethoxyl group, a propoxyl group, or a phenoxyl group; a cyano group; and a halogen atom such as fluorine, chlorine, bromine, or iodine.

Specific examples of the general formula (1) include, but not limited to, the following structures.

A1 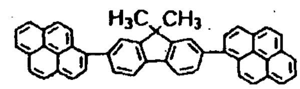

A2 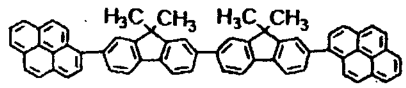

A3 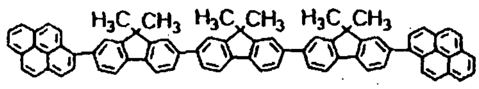

A4 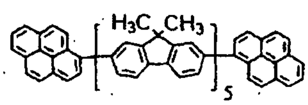

A5 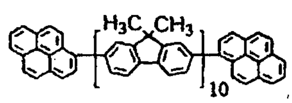

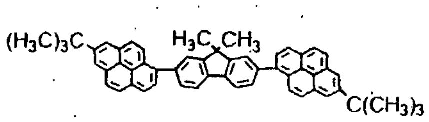

A6

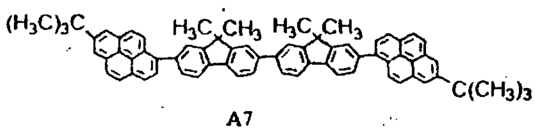

A7

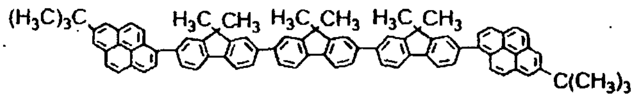

A8

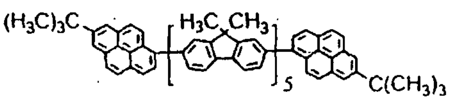

A9

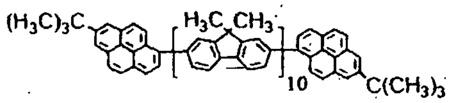

A10

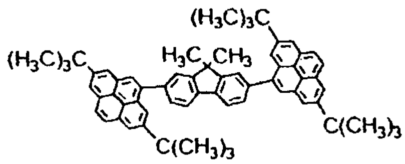

A11

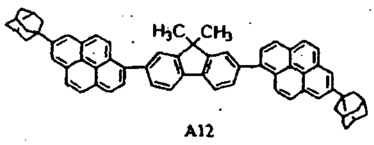

A12

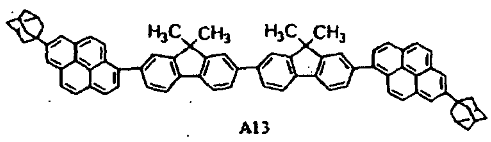

A13

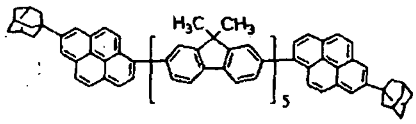

A14

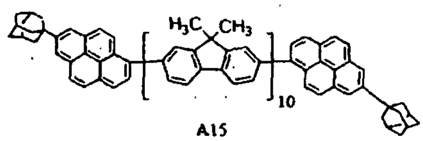

A15

A16

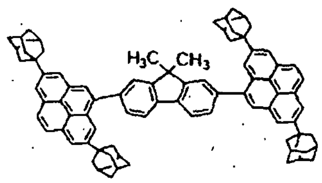

A17

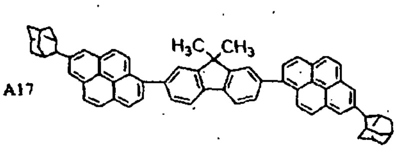

A18

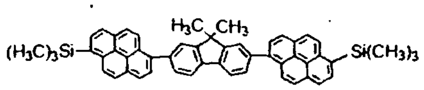

A19

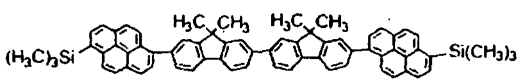

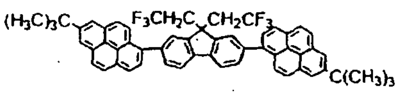

A20

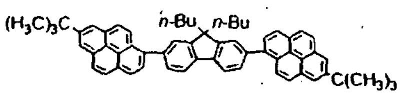

A21

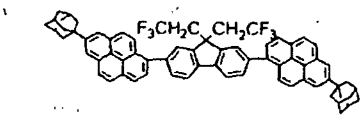

A22

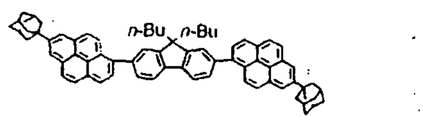

A23

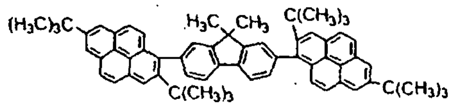

A24

Specific examples of the general formula (2) include, but not limited to, the following structures.

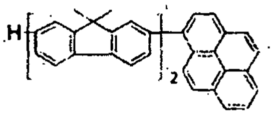

B1

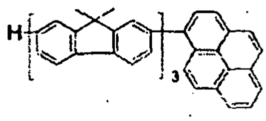

B2

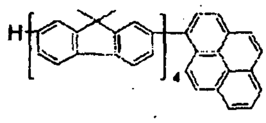

B3

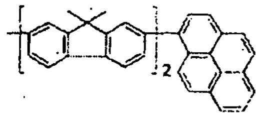

B4

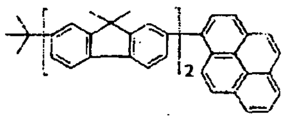

B5

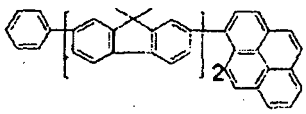

B6

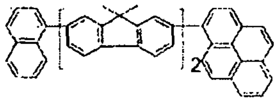

B7

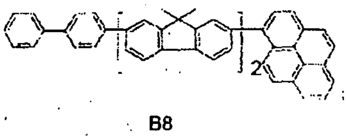

B8

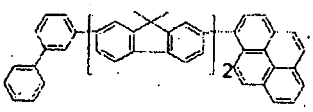

B9

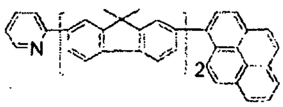

B10

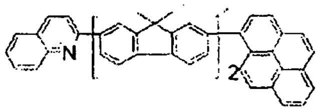

B11

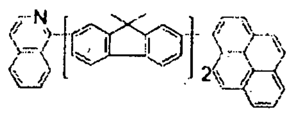

B12

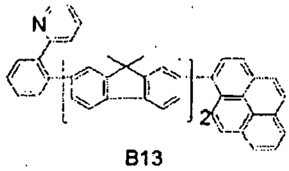

B13

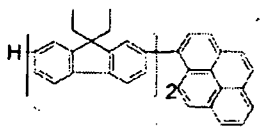

B14

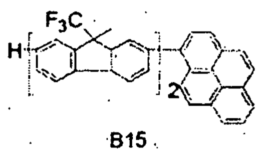

B15

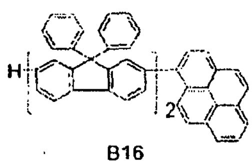

B16

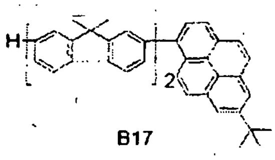

B17

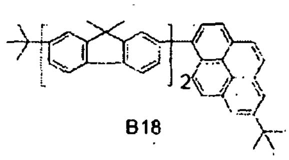

B18

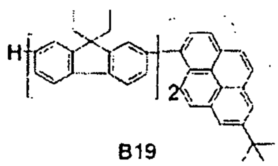

B19

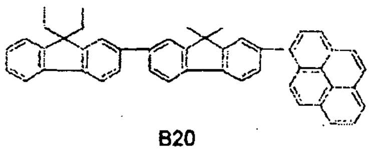

B20

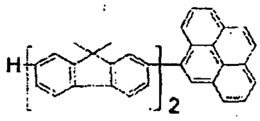

B21

Specific examples of the general formula (3) include, but not limited to, the following structures.

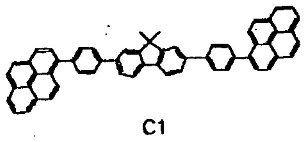

C1

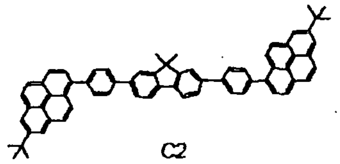

C2

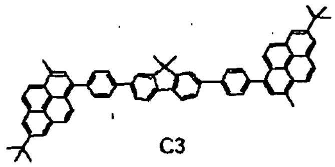

C3

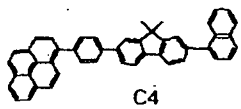

C4

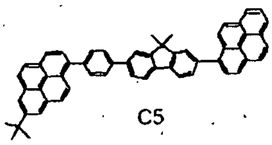

C5

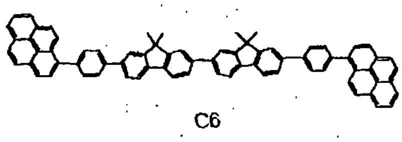

C6

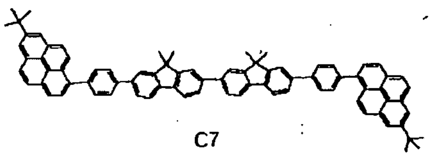

C7

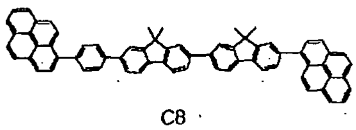

C8

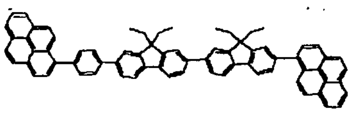

C9

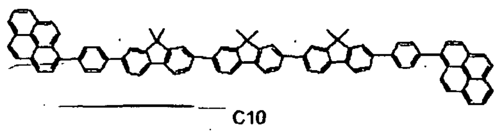

C10

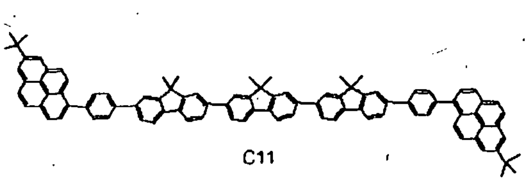

C11

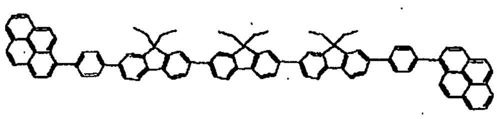

C12

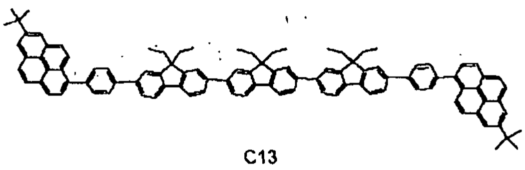

C13

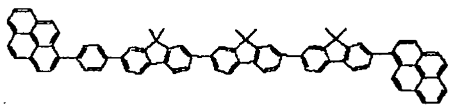

C14

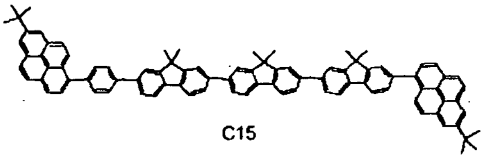

C15

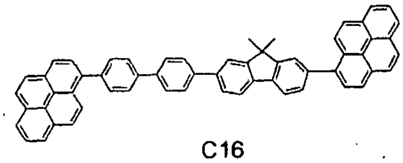

C16

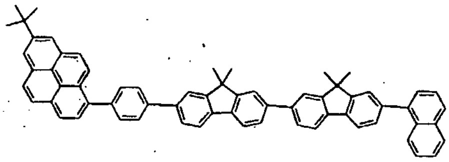

C17

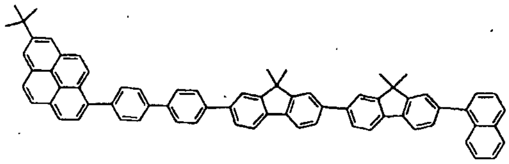

C18

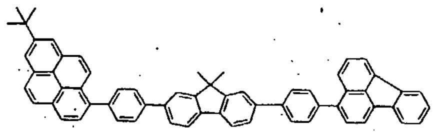

C19

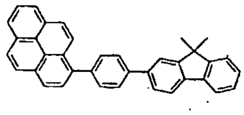

C20

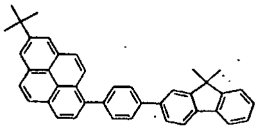

C21

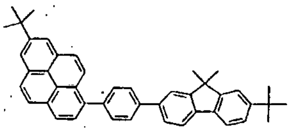

C22

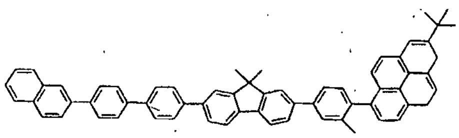

C23

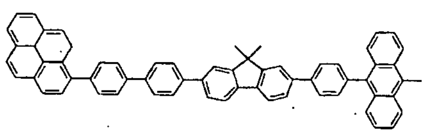

C24

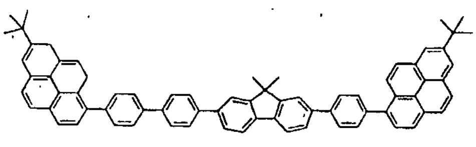

C25

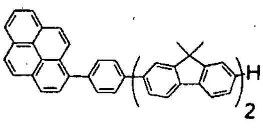

C26

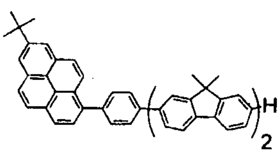

C27

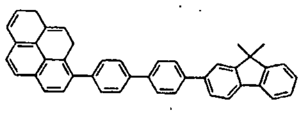

C28

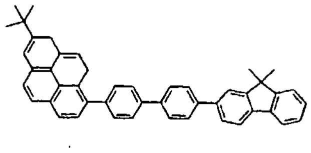

C29

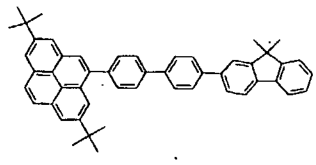

C30

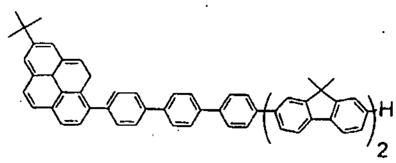

C31

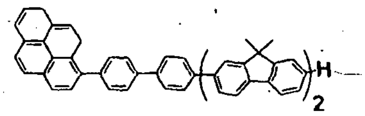

C32

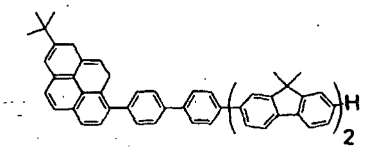

C33

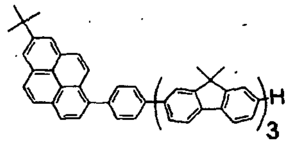

C34

The host material of the present invention which is represented by any one of the general formulae (1) to (3) can obtain the following excellent properties because of its molecular structure:

(1) the host material is extremely excellent in amorphous property, and has high heat resistance;
(2) each of both an electron and a hole can easily obtain a suitable carrier injection level; and
(3) the host material can easily obtain an energy gap optimum for blue light emission, that is, an energy gap of 2.7 eV or more to 3.4 eV or less.

Further, a combination of the host material and the luminescent dopant having a fluoranthene skeleton can easily provide the following excellent properties:

(4) energy favorably transfers from the host to the dopant, provided that it is important for an energy gap E1 of the luminescent dopant and an energy gap E2 of the host material to satisfy the relationship of E1 < E2; and
(5) compatibility between the host having a pyrene skeleton and the luminescent dopant having a fluoranthene skeleton is so high that the luminescent dopant is favorably dispersed in a light-emitting layer, whereby reductions in efficiency and lifetime of a light-emitting device resulting from the aggregation of the luminescent dopant can be alleviated, provided that particularly good result can be obtained when the host material and the luminescent dopant are each a hydrocarbon compound, and of the above-mentioned host materials, a material having a sum of the number of pyrene skeletons and the number of fluorene skeletons in one molecule of 3 or 4 is particularly preferable in order that such material has together an excellent electron mobility, excellent amorphous property, and excellent property in film formation by evaporation.

In addition, a luminescent dopant having a fluoranthene skeleton and a fluorene skeleton is particularly good, and is preferably combined with a host material represented by any one of the general formulae (1) to (3). This is because both the luminescent dopant and the host contain the same fluorene skeleton. Examples of the luminescent dopant having a fluoranthene skeleton and a fluorene skeleton include, but not limited to, the following materials.

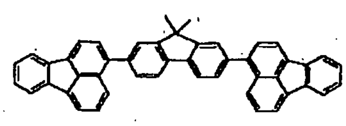

D1

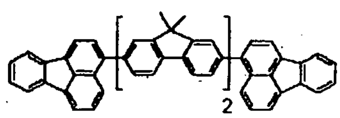

D2

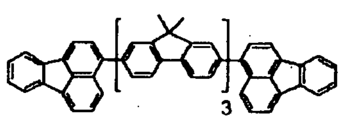

D3

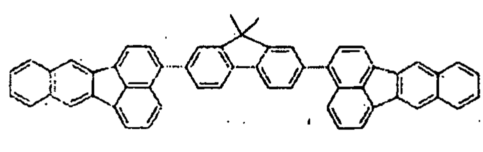

D4

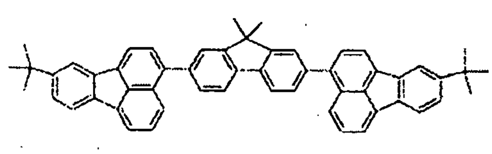

D5

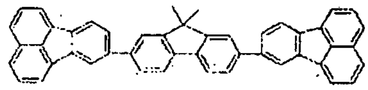

D6

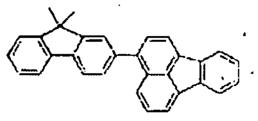

D7

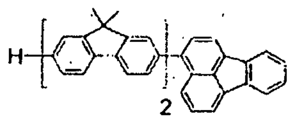

D8

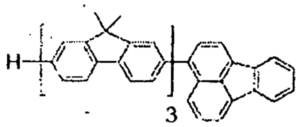

D9

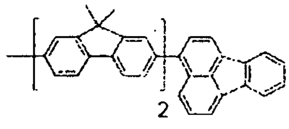

D10

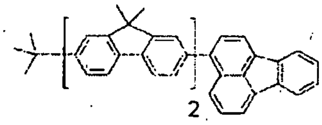

D11

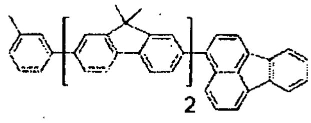

D12

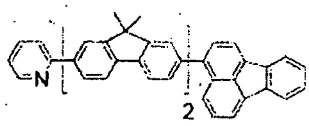

D13

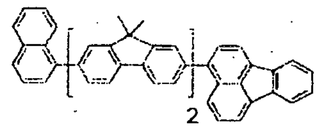

D14

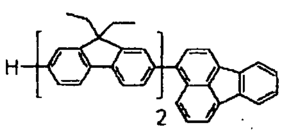

D15

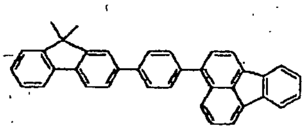

D16

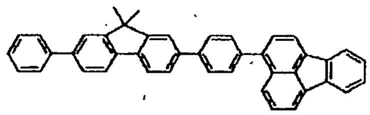

D17

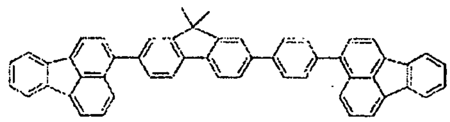

D18

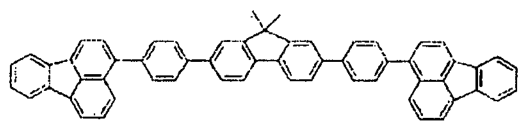

D19

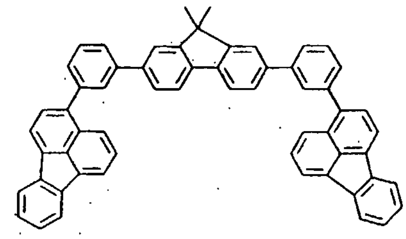

D20

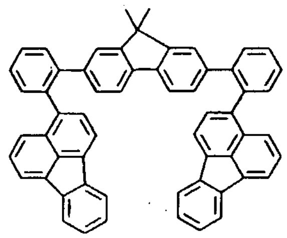

D21

In the present invention, it is desirable that the luminescent dopant containing a fluoranthene skeleton be chemically stable against reduction because an electron is trapped in the luminescent dopant. Further, the deformation of the structure of the dopant from a neutral state in a state where the electron is trapped is preferably small. A LUMO is considered to be preferably delocalized in a relatively wide region in a molecule in order that the deformation may be small.

The luminescent dopant is mixed in the light-emitting layer at a concentration of preferably 0.1 wt% or more to 35 wt% or less, or more preferably 1 wt% or more to 15 wt% or less in consideration of the electron trap mechanism and the energy transfer from the host to the luminescent dopant described above.

An energy gap can be determined from measurement of a visible light-ultraviolet absorption spectrum. In the present invention, the energy gap was determined from an absorption edge of a thin film formed on a glass substrate by using a spectrophotometer U-3010 manufactured by Hitachi, Ltd. as a device.

An ionization potential and a highest occupied molecular orbital (HOMO) energy were measured by employing photoelectron spectroscopy in the air (measuring instrument name AC-1 manufactured by RIKENKIKI CO., LTD).

An electron affinity and a lowest unoccupied molecular orbital (LUMO) energy can be calculated from the measured value for the energy gap and the above-mentioned HOMO energy. In the present invention, a method of calculating the LUMO energy from the value for the HOMO energy and the energy gap was employed. That is, LUMO energy = HOMO energy + energy gap.

In addition, a carrier mobility can be measured by a transient current measurement using a time-of-flight (TOF) method. In the present invention, a thin film having a thickness of about 2 $\mu$m was produced on a glass substrate with ITO by a vacuum evaporation method, and, furthermore, aluminum was deposited to serve as a counter electrode. A value for the carrier mobility of the sample at an electric field intensity of $4 \times 10^5$ V/cm was measured by using a TOF measuring apparatus (TOF-301 manufactured by OPTEL).

A hole transportable material preferably has excellent mobility for facilitating the injection of a hole from an anode and transporting the injected hole to a light-emitting layer. Examples of a low-molecular-weight material and a high-molecular-weight material each having hole injection/transport performance include, but of course not limited to, a triarylamine derivative, a phenylenediamine derivative, a triazole derivative, an oxadiazole derivative, an imidazole derivative, a pyrazoline derivative, a pyrazolone derivative, an oxazole derivative, a fluorenone derivative, a hydrazone derivative, a stilbene derivative, a phthalocyanine derivative, a porphyrin derivative, poly(vinylcarbazole), poly(silylene), poly(thiophene), and any other conductive polymer.

An electron injectable/transportable material can be arbitrarily selected from materials each having a function for facilitating the injection of an electron from a cathode and transporting the injected electron to the light-emitting layer, and is selected in consideration of, for example, a balance between the carrier mobility of the,material and the carrier mobility of a hole transport material. Examples of a material having electron injection/transport performance include, but of course not limited to, an oxadiazole derivative, an oxazole derivative, a thiazole derivative, a thiadiazole derivative, a pyrazine derivative, a triazole derivative, a triazine derivative, a perylene derivative, a quinoline derivative, a quinoxaline derivative, a fluorenone derivative, an anthrone derivative, a phenanthroline derivative, and an organometallic complex. In addition, a material having a large ionization potential can be used also as a hole block material.

A layer composed of an organic compound in the organic light-emitting device of the present invention is obtained by any one of various methods. In general, a thin film is formed by a vacuum evaporation method, an ionized evaporation method, sputtering, or plasma CVD. Alternatively, a thin film is formed by: dissolving a material for the film in an appropriate solvent, and subjecting the solution to a known application method (such as a spin coating method, a dipping method, a cast method, an LB method, or an inkjet method). In particular, when a film is formed by the application method, the film can be formed in combination with an appropriate binder resin.

The above-mentioned binder resin can be selected from a wide variety of binding resins, and examples of the binder resin include, but not limited to, a polyvinyl carbazole resin, a polycarbonate resin, a polyester resin, a polyallylate resin, a polystyrene resin, an ABS resin, a polybutadiene resin, a polyurethane resin, an acrylic resin, a methacrylic resin, a butyral resin, a polyvinyl acetal resin, a polyamide resin, a polyimide resin, a polyethylene resin, a polyether sulfone resin, a diallyl phthalate resin, a phenol resin, an epoxy resin, a silicone resin, a polysulfone resign, and a urea resin. In addition, one kind of them may be used alone, or two or more kinds of them may be mixed to serve as a copolymer. Further, as required, a known additive such as a plasticizer, an antioxidant, or a UV absorber may be used in combination with the binder resin.

A material for the anode desirably has as large a work function as possible, and examples of a material that can be used include: metal elements such as gold, platinum, silver, copper, nickel, palladium, cobalt, selenium, vanadium, and tungsten, or alloys of the metal elements; and metal oxides such as tin oxide, zinc oxide, indium oxide, indium tin oxide (ITO), and indium zinc oxide. A conductive polymer such as polyaniline, polypyrrole, polythiophene, or polyphenylene sulfide can also be used. Each of those electrode substances can be used alone, or two or more of them can be used in combination. In addition, the anode may be constituted of a single layer, or may be constituted of a plurality of layers.

On the other hand, a material for the cathode desirably has as small a work function as possible, and examples of a material that can be used include: metal elements such as lithium, sodium, potassium, calcium, magnesium, aluminum, indium, ruthenium, titanium, manganese, yttrium, silver, lead, tin, and chromium; and alloys each composed of two or more of the metal elements such as a lithium-indium alloy, a sodium-potassium alloy, a magnesium-silver alloy, an aluminum-lithium alloy, an aluminum-magnesium alloy, and a magnesium-indium alloy. A metal oxide such as indium tin oxide (ITO) can also be used. Each of those electrode substances can be used alone, or two or more of them can be used in combination. In addition, the cathode may be constituted of a single layer, or may be constituted of a plurality of layers.

In addition, at least one of the anode and the cathode is desirably transparent or semi-transparent.

A substrate to be used in the present invention is not particularly limited, but an opaque substrate such as a metal substrate or a ceramic substrate, or a transparent substrate such as glass, quartz, or a plastic sheet is used. In

addition, a color filter film, a fluorescent color conversion filter film, a dielectric reflective film, or the like can be used in the substrate to control colored light. In addition, a device can be produced by producing a thin film transistor (TFT) on the substrate and by connecting the TFT to the substrate.

Further, a two-dimensional array of TFTs to serve as pixels can be used as a display. For example, an array of light-emitting pixels for three colors, that is, red, green, and blue colors can be used as a full-color display.

In addition, with regard to the direction of extracting light from the device, both a bottom emission constitution (constitution in which light is extracted from a substrate side) and a top emission constitution (constitution in which light is extracted from the side opposite to the substrate) are available.

The produced device may be provided with a protective layer or a sealing layer for the purpose of preventing the device from contacting with, for example, oxygen or moisture. Examples of the protective layer include a diamond thin film; an inorganic material film made of, for example, a metal oxide or a metal nitride; a polymer film such as a fluorine resin, polyparaxylene, polyethylene, a silicone resin, or a polystyrene resin; and a photocurable resin. In addition, the device itself can be covered with glass, a gas impermeable film, a metal, or the like, and the device itself can be packaged with an appropriate sealing resin.

Hereinafter, the present invention will be described more specifically by way of the following Examples. However, the present invention is not limited to these Examples.

(Example 1)

Indium tin oxide (ITO) was formed into a film having a thickness of 130 nm by a sputtering method to serve as an anode on a glass substrate as a substrate, and the resultant was used as a transparent, conductive supporting substrate. The resultant was subjected to ultrasonic cleaning in acetone and isopropyl alcohol (IPA) sequentially, and was then subjected to boiling cleaning in IPA, followed by drying. Further, the resultant was subjected to UV/ozone cleaning.

A chloroform solution was prepared by using Compound 1 shown below as a hole transport material in such a manner that the concentration of the compound would be 0.1 wt%.

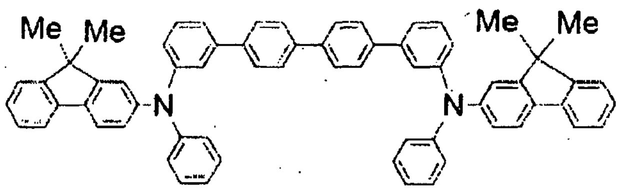

Compound 1

The solution was dropped onto the above-mentioned ITO electrode, and the whole was subjected to spin coating initially at a number of revolutions of 500 RPM for 10 seconds and then at a number of revolutions of 1,000 RPM for 1 minute, whereby a film was formed. After that, the resultant was dried for 10 minutes in a vacuum oven at 80°C, whereby the solvent in the thin film was completely removed. The formed hole transport layer had a thickness of 15 nm.

Next, a light-emitting layer was formed by the co-deposition of Compound 2 shown below as a host material and Compound 3 shown below as a luminescent dopant from different boats. The layer had a concentration of Compound 3 of 8 wt% and a thickness of 30 nm.

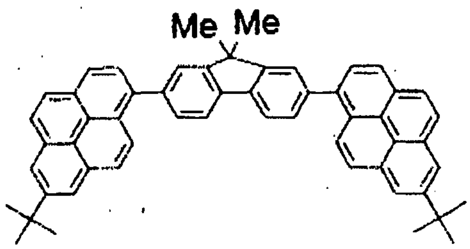

Compound 2

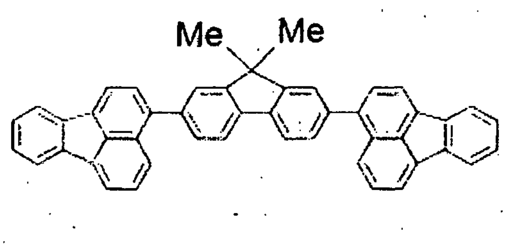

Compound 3

Further, Bphen shown below was subjected to vacuum deposition to form an electron transport layer. The electron transport layer had a thickness of 30 nm.

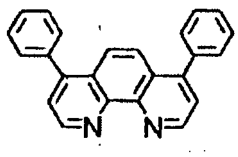

BPhen

The above-mentioned organic layer was formed under conditions including: a degree of vacuum of $1.0 \times 10^{-4}$ Pa at the time of deposition; and a film formation rate of about 0.1 nm/sec or more to 0.3 nm/sec or less.

Next, lithium fluoride (LiF) was formed into a film-having a thickness of 0.5 nm on the previous organic layer by a vacuum deposition method. Further, an aluminum film having a thickness of 150 nm was provided as an electron injection electrode (cathode) on the resultant by a vacuum deposition method, whereby an organic light-emitting device was produced. The degree of vacuum at the time of the deposition was $1.0 \times 10^{-4}$ Pa, lithium fluoride was formed into a film at a film formation rate of 0.05 nm/sec, and aluminum was formed into a film at a film formation rate of 1.0 nm/sec or more to 1.2 nm/sec or less.

The resultant organic light-emitting device was covered with a protective glass plate and sealed with an acrylic resin-based adhesive air atmosphere in order that the deterioration of the device might not occur owing to the adsorption of moisture.

A voltage of 4.5 V was applied to the thus-obtained device while the ITO electrode (anode) was used as a positive electrode and the aluminum electrode (cathode) was used as a negative electrode. As a result, the device was observed to emit blue light derived from Compound 3 and having an emission luminance of 3,800 cd/$m^2$, an emission efficiency of 5.3 lm/W, and a maximum emission wavelength of 463 nm.

Further, a voltage was applied to the device under a nitrogen atmosphere with a current density kept at 30 mA/$cm^2$. As a result, a luminance half time was as long as about 700 hours.

The thin films of the host material and luminescent dopant of the light-emitting layer were each formed by vacuum deposition, and the HOMO energy of each of the thin films was measured with a photoelectron spectrometer (apparatus name AC-1) in the air. In addition, furthermore, the energy gap and LUMO energy of each of the thin films were calculated by measuring an ultraviolet-visible light absorption spectrum (apparatus name U-3010). The result showed that the energy gap of the host material was larger than that of the luminescent dopant by 0.16 eV. In addition, the result showed that the LUMO energy EL2 of the host material was -2.72 eV, the LUMO energy EL1 of the luminescent dopant was -3.06 eV, and EL2 - EL1 = 0.34 eV.

The energy gap of each of the hole transport material (Compound 1) and the electron transport material (BPhen) was similarly measured. The energy gap of the hole transport material was 3.25 eV, which was larger than 3.15 eV. In addition, the energy gap of the electron transport material was 3.57 eV, which was larger than 3.00 eV.

In order to measure the carrier mobility of the host material alone of the light-emitting layer, the host material (Compound 2) was formed into a layer having a thickness of 2 μm on the glass substrate with ITO by deposition. Subsequently, an aluminum film having a thickness of 150 nm was formed by a vacuum deposition method, whereby a device for mobility measurement was obtained. The surface of the formed film of the resultant device was covered with a protective glass plate in a dry air atmosphere in order that the device might be prevented from deteriorating owing to the adsorption of moisture to the surface. Then, a UV-based adhesive was loaded into a gap between the surface and the glass plate, and was cured.

The electron mobility and hole mobility of the device at an electric field intensity of $4 \times 10^5$ V/cm were measured by using a time-of-flight measuring apparatus (TOF-301 manufactured by OPTEL). The host material had an electron

mobility of $1 \times 10^{-3}$ $cm^2/Vs$ and a hole mobility of $2 \times 10^{-4}$ $cm^2/Vs$. It was found that the electron mobility of the host material was larger than the hole mobility of the host material. It was also found that the electron mobility of the host material was larger than $1 \times 10^{-4}$ $cm^2/Vs$ .

Next, in order to measure the carrier mobility of the light-emitting layer, the host material (Compound 2) and the luminescent dopant material (Compound 3) were formed into a layer having a thickness of 2 μm on the glass substrate with ITO by co-deposition in the same manner as in the light-emitting layer of the organic light-emitting device. Subsequently, an aluminum film having a thickness of 150 nm was formed by a vacuum deposition method, whereby a device for mobility measurement was obtained. The surface of the formed film of the resultant device was covered with a protective glass plate in a dry air atmosphere in order that the device might be prevented from deteriorating owing to the adsorption of moisture to the surface. Then, a UV-based adhesive was loaded into a gap between the surface and the glass plate, and was cured.

The electron mobility of the device at an electric field intensity of $4 \times 10^5$ V/cm was measured by using a time-of-flight measuring apparatus (TOF-301 manufactured by OPTEL). The light-emitting layer had an electron mobility of $4 \times 10^{-7}$ $cm^2/Vs$. It was found that the electron mobility of the light-emitting layer was lower than that of the host material alone by one or more orders of magnitude.

(Example 2)

A light-emitting device was produced in the same manner as in Example 1 except that the host material of a light-emitting layer was constituted of Compound 4 shown below.

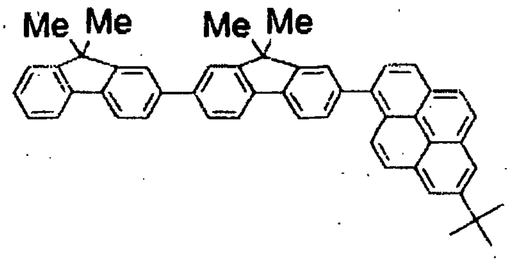

Compound 4

A voltage of 4.5 V was applied to the thus-obtained device while the ITO electrode (anode) was used as a positive electrode and the aluminum electrode (cathode) was used as a negative electrode. As a result, the device was observed to emit blue light derived from Compound 3 and having an emission luminance of 2,500 $cd/m^2$, an emission efficiency of 5.5 lm/W, and a maximum emission wavelength of 460 nm.

Further, a voltage was applied to the device under a nitrogen atmosphere with a current density kept at 30 $mA/cm^2$. As a result, a luminance half time was as long as about 1,400 hours.

The thin films of the host material and luminescent dopant of the light-emitting layer were each formed by vacuum deposition, and the HOMO energy of each of the thin films was measured with a photoelectron spectrometer (apparatus name AC-1) in the air. In addition, furthermore, the energy gap and LUMO energy of each of the thin films were calculated by measuring an ultraviolet-visible light absorption spectrum (apparatus name U-3010).

The result showed that the energy gap of the host material was larger than that of the luminescent dopant by 0.18 eV. In addition, the result showed that the LUMO energy EL2 of the host material was -2.64 eV, the LUMO energy EL1 of the luminescent dopant was -3.06 eV, and EL2 - EL1 = 0.42 eV.

The carrier mobility of the host material (Compound 4) alone of the light-emitting layer was measured in the same manner as in Example 1. The host material had an electron mobility of $7 \times 10^{-4}$ $cm^2/Vs$ and a hole mobility of $2 \times 10^{-4}$ $cm^2/Vs$. It was found that the electron mobility of the host material was larger than the hole mobility of the host material. It was also found that the electron mobility of the host material was larger than $1 \times 10^{-4}$ $cm^2/Vs$.

Next, the electron mobility of the light-emitting layer (mixed film containing Compound 4 as a host material and doped with 8 wt% of Compound 3 as a luminescent dopant) was measured in the same manner as in Example 1. The light-emitting layer had an electron mobility of $2 \times 10^{-7}$ $cm^2/Vs$. It was found that the electron mobility of the light-emitting layer was lower than that of the host material alone by one or more orders of magnitude.

(Comparative Example 1)

A light-emitting device was produced in the same manner as in Example 1 except that a light-emitting layer was constituted of only a host material.

A voltage of 4.5 V was applied to the device while the ITO electrode (anode) was used as a positive electrode and the aluminum electrode (cathode) was used as a negative electrode. As a result, the device was observed to emit blue light derived from Compound 2 and having an emission luminance of 2,000 cd/m$^2$, an emission efficiency of 3.4 lm/W, and a maximum emission wavelength of 460,nm.

Further, a voltage was applied to the device under a nitrogen atmosphere with a current density kept at 30 mA/cm$^2$. As a result, a luminance half time was about 100 hours, which was shorter than that of Example 1.

(Example 3)

A light-emitting device was produced in the same manner as in Example 2 except that a material for an electron transport layer was changed to 2,9-bis[2-(9,9-dimethylfluorenyl)]phenanthroline.

A voltage of 4.5 V was applied to the device while the ITO electrode (anode) was used as a positive electrode and the aluminum electrode (cathode) was used as a negative electrode. As a result, the device was observed to emit blue light derived from Compound 3 and having an emission luminance of 2,400 cd/m$^2$, an emission efficiency of 5.1 lm/W, and a maximum emission wavelength of 462 nm.

Further, a voltage was applied to the device under a nitrogen atmosphere with a current density kept at 30 mA/cm$^2$. As a result, a luminance half time was as long as about 1,600 hours.

The measured energy gap of the electron transport material was 3.08 eV, which was larger than 3.00 eV.

(Comparative Example 2)

A light-emitting device was produced in the same manner as in Example 3 except that an electron transport material was changed to Alq represented by the following formula.

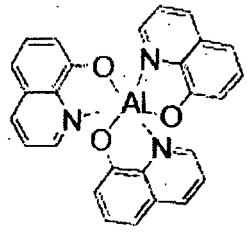

Alq

The device was driven by using the ITO electrode (anode) as a positive electrode and the aluminum electrode (cathode) as a negative electrode. The device was observed to emit bluish green light derive from Compound 3 and the electron transport material at an applied voltage of 4.5 V, but the device did not emit pure blue light.

The measured energy gap of the electron transport material (Alq) was 2.69 eV, which was smaller than 3.00 eV.

(Comparative Example 3)

A light-emitting device was produced in the same manner as in Example 3 except that a hole transport material was changed to DFLDPBi represented by the following formula.

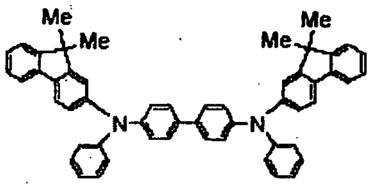

DFLDPBi

A voltage of 4.5 V was applied to the thus-obtained device by using the ITO electrode (anode) as a positive electrode and the aluminum electrode (cathode) as a negative electrode. As a result, the device was observed to emit blue light derived from Compound 3 and having an emission luminance of 660 cd/m$^2$ and a maximum emission wavelength

of 460 nm. However, the emission efficiency of the device was 1.9 lm/W, which was lower than that of Example 3.

The measured energy gap of the hole transport material (DFLDPBi) was 2.97 eV, which was smaller than 3.15 eV.

(Comparative Example 4)

A light-emitting device was produced in the same manner as in Example 3 except that a hole transport material was changed to αNPD represented by the following formula.

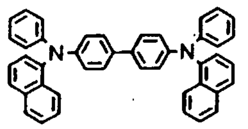

αNPD

A voltage of 4.5 V was applied to the thus-obtained device by using the ITO electrode (anode) as a positive electrode and the aluminum electrode (cathode) as a negative electrode. As a result, the device was observed to emit blue light derived from Compound 3 and having an emission luminance of 570 $cd/m^2$ and a maximum emission wavelength of 463 nm. However, the emission efficiency of the device was 2.4 lm/W, which was lower than that of Example 3.

Further, a voltage was applied to the device under a nitrogen atmosphere with a current density kept at 30 $mA/cm^2$. As a result, a luminance half time was about 200 hours, which was shorter than that of Example 3.

The measured energy gap of the hole transport material (αNPD) was 3.10 eV, which was smaller than 3.15 eV.

(Example 4)

A chloroform solution to be applied to a glass substrate with ITO prepared in the same manner as in Example 1 was prepared by using DFLDPBi as a hole injection material in such a manner that the concentration of the material would be 0.13 wt%.

The solution was dropped onto the above-mentioned ITO electrode, and the whole was subjected to spin coating initially at a number of revolutions of 500 RPM for 10 seconds and then at a number of revolutions of 1,000 RPM for 1 minute, whereby a film was formed. After that, the resultant was dried for 10 minutes in a vacuum oven at 80°C, whereby the solvent in the thin film was completely removed. The formed hole transport layer had a thickness of 18 nm.

Next, Compound 5 shown below was deposited to form a hole transport layer having a thickness of 15 nm.

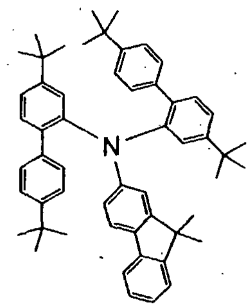

Compound 5

Next, a light-emitting layer was formed by simultaneously depositing Compound 6 shown below as a host material and Compound 3 as a luminescent dopant from different boats. The light-emitting layer had a concentration of Compound 3 of 5 wt% and a thickness of 30 nm.

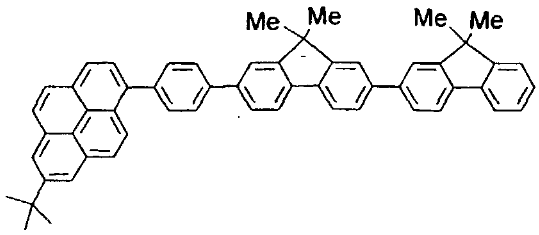

Compound 6

Further, steps subsequent to the formation of an electron transport layer were performed in the same manner as in Example 3.

A voltage of 4.5 V was applied to the device by using the ITO electrode (anode) as a positive electrode and the aluminum electrode (cathode) as a negative electrode. As a result, the device was observed to emit blue light having an emission luminance of 1,100 cd/$m^2$, an emission efficiency of 6.9 lm/W, and CIE xy chromaticity coordinates of (0.15, 0.19).

Further, a voltage was applied to the device under a nitrogen atmosphere with a current density kept at 30 mA/$cm^2$. As a result, a luminance half time was as long as about 1,200 hours.

The measured energy gap of the hole transport material (Compound 5) was 3.25 eV, which was larger than 3.15 eV.

In addition, the measured energy gap of the host material (Compound 6) of the light-emitting layer was found to be larger than that of the dopant material by 0.27 eV.

It was also found that the LUMO energy EL2 of the host material was -2.62 eV, the LUMO energy EL1 of the luminescent dopant was -3.06 eV, and EL2 - EL1 = 0.44 eV.

(Example 5)

A light-emitting device was produced in the same manner as in Example 3 except that the dopant material of a light-emitting layer was changed to Compound 7 represented by the following formula and the mixed concentration of the dopant material was changed to 5%.

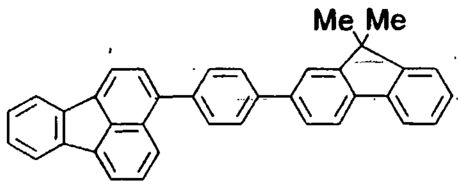

Compound 7

A voltage of 4.5 V was applied to the device by using the ITO electrode (anode) as a positive' electrode and the aluminum electrode (cathode) as a negative electrode. As a result, the device was observed to emit blue light having an emission luminance of 2,100 cd/$m^2$, an emission efficiency of 4.5 lm/W, and CIE xy chromaticity coordinates of (0.15, 0.17).

Further, a voltage was applied to the device under a nitrogen atmosphere with a current density kept at 30 mA/$cm^2$. As a result, a luminance half time was as long as about 1,500 hours.

In addition, the measured energy gap of the dopant material (Compound 7) of the light-emitting layer was found to be smaller than that of the host material by 0.09 eV.

It was also found that the LUMO energy EL2 of the host material was -2.64 eV, the LUMO energy EL1 of the luminescent dopant was -3.17 eV, and EL2 - EL1 = 0.53 eV.

(Example 6)

A light-emitting device was produced in the same manner as in Example 3 except that the dopant material of a light-emitting layer was changed to Compound 8 represented by the following formula and the mixed concentration of the dopant material was changed to 5%.

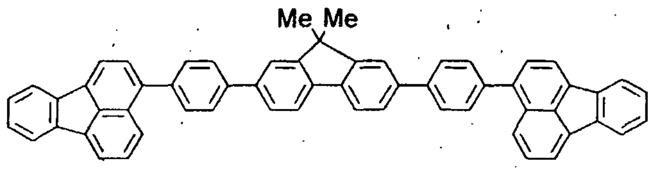

Compound 8

A voltage of 4.5 V was applied to the device by using the ITO electrode (anode) as a positive electrode and the aluminum electrode (cathode) as a negative electrode. As a result, the device was observed to emit blue light having an emission luminance of 2,300 cd/m$^2$, an emission efficiency of 5.0 lm/W, and CIE xy chromaticity coordinates of (0.15, 0.18).

Further, a voltage was applied to the device under a nitrogen atmosphere with a current density kept at 30 mA/cm$^2$. As a result, a luminance half time was as long as about 1,300 hours.

In addition, the measured energy gap of the dopant material (Compound 8) of the light-emitting layer was found to be smaller than that of the host material by 0.12 eV.

It was also found that the LUMO energy EL2 of the host material was -2.64 eV, the LUMO energy EL1 of the luminescent dopant was -3.15 eV, and EL2 - EL1 = 0.51 eV.

(Example 7)

A light-emitting device was produced in the same manner as in Example 3 except that the host material of a light-emitting layer was changed to Compound 9 represented by the following formula, the concentration of a dopant material was changed to 12% and the thickness of the light-emitting layer was changed to 40 nm.

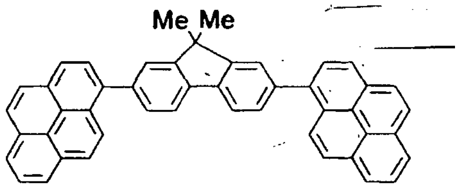

Compound 9

A voltage of 4.5 V was applied to the device by using the ITO electrode (anode) as a positive electrode and the aluminum electrode (cathode) as a negative electrode. As a result, the device was observed to emit blue light having an emission luminance of 4,500 cd/m$^2$, an emission efficiency of 6.8 lm/W, and CIE xy chromaticity coordinates of (0.15, 0.19).

Further, a voltage was applied to the device under a nitrogen atmosphere with a current density kept at 10 mA/cm$^2$. As a result, a luminance half time was as long as about 1,000 hours.

In addition, the measured energy gap of the host material (Compound 9) of the light-emitting layer was found to be larger than that of the dopant material by 0.15 eV.

It was also found that the LUMO energy EL2 of the host material was -2.78 eV, the LUMO energy EL1 of the luminescent dopant was -3.06 eV, and EL2 - EL1 = 0.28 eV.

(Comparative Example 5)

A light-emitting device was produced in the same manner as in Example 3 except that the dopant material of a light-emitting layer was changed to Compound 10 represented by the following formula.

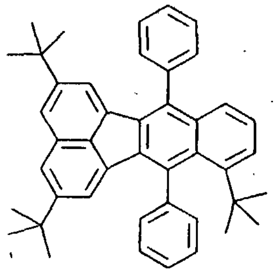

Compound 10

A voltage of 4.5 V was applied to the device by using the ITO electrode (anode) as a positive electrode and the aluminum electrode (cathode) as a negative electrode. As a result, the device was observed to emit blue light having an emission luminance of 4,800 $cd/m^2$, an emission efficiency of 5.6 lm/W, and CIE xy chromaticity coordinates of (0.15, 0.16).

Further, a voltage was applied to the device under a nitrogen atmosphere with a current density kept at 10 $mA/cm^2$. As a result, a luminance half time was about 150 hours, which was shorter than the lifetime of Example 7.

In addition, the measured energy gap of the dopant material (Compound 10) of the light-emitting layer was found to be smaller than that of the host material by 0.04 eV.

It was also found that the LUMO energy EL2 of the host material was -2.78 eV, the LUMO energy EL1 of the luminescent dopant was -2.91 eV, and EL2 - EL1 = 0.13 eV, which was smaller than 0.15 eV.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An organic blue-light-emitting device, comprising:

   a pair of electrodes composed of an anode and a cathode; and
   a layer composed of an organic compound and interposed between the pair of electrodes,
   wherein the layer has a light-emitting region and contains a first compound including a fluoranthene skeleton and a second compound
   including a pyrene skeleton;
   the second compound has an energy gap larger than an energy gap of the first compound; and
   a lowest unoccupied molecular orbital energy EL1 of the first compound and a lowest unoccupied molecular orbital energy EL2 of the second compound satisfy a relationship of EL2 - EL1 $\geq$ 0.15 eV, and
   a highest occupied molecular orbital energy EH1 of the first compound and a highest occupied molecular orbital energy EH2 of the second compound satisfy a relationship of EH2 - EH1 > 0 eV,
   wherein the second compound is a host material and the first compound is a luminescent dopant material,
   wherein the electron mobility of the host material is larger than the hole mobility of the host material, and
   the energy gaps and the molecular orbital energies being determined by the methods described in the description.

2. An organic light-emitting device according to claim 1, wherein the second compound has the pyrene skeleton and a fluorene skeleton.

3. An organic light-emitting device according to claim 2, wherein the second compound is represented by the following general formula (1):

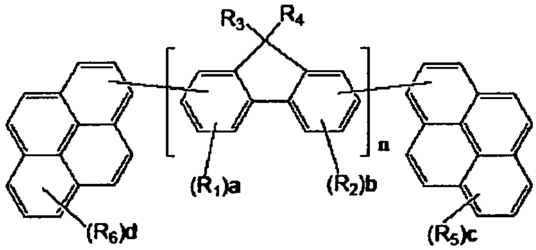

(1)

wherein $R_1$ and $R_2$ groups each represent a hydrogen atom, a substituted or unsubstituted alkyl group, a substituted or unsubstituted aralkyl group, a substituted or unsubstituted aryl group, a substituted or unsubstituted heterocyclic group, a substituted amino group, a cyano group, or a halogen atom; $R_1$ groups bonded to different fluorenediyl groups may be the same or different, and $R_2$ groups bonded to different fluorenediyl groups may be the same or different; and $R_1$ groups bonded to the same fluorenediyl group may be the same or different, $R_2$ groups bonded to the same fluorenediyl group may be the same or different, and $R_1$ and $R_2$ groups bonded to the same fluorenediyl group may be the same as or different from each other;
$R_3$ and $R_4$ groups each represent a hydrogen atom, a substituted or unsubstituted alkyl group, a substituted or unsubstituted aralkyl group, a substituted or unsubstituted aryl group, or a substituted or unsubstituted heterocyclic group; $R_3$ groups bonded to different fluorenediyl groups may be the same or different, and $R_4$ groups bonded to different fluorenediyl groups may be the same or different, and $R_3$ and $R_4$ groups bonded to the same fluorenediyl group may be the same as or different from each other;
$R_5$ and $R_6$ groups each represent a hydrogen atom, a substituted or unsubstituted alkyl group, a substituted or unsubstituted aralkyl group, a substituted or unsubstituted aryl group, a substituted or unsubstituted heterocyclic group, a substituted amino group, a cyano group, or a halogen atom; $R_5$ groups may be the same or different, $R_6$ groups may be the same or different, and $R_5$ and $R_6$ groups may be the same as or different from each other; and
a and b each represent an integer of 1 to 3 and may be the same as or different from each other, c and d each represent an integer of 1 to 9 and may be the same as or different from each other, and n represents an integer of 1 to 10.

**4.** An organic light-emitting device according to claim 2, wherein the second compound is represented by the following general formula (2):

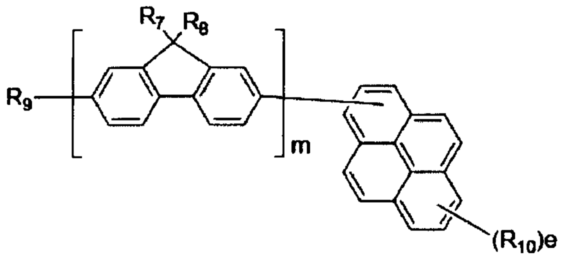

(2)

wherein $R_7$ and $R_8$ groups each represent a hydrogen atom, a substituted or unsubstituted alkyl group, a substituted or unsubstituted aralkyl group, a substituted or unsubstituted aryl group, or a substituted or unsubstituted heterocyclic group; and $R_7$ and $R_8$ groups may be the same or different;
$R_9$ group represents a hydrogen atom, a linear, branched, or cyclic alkyl group (one or more methylene groups of the alkyl group may be substituted by -O-,
-S-, -CO-, -CO-O-, -O-CO-, -CH=CH-, -C≡C-, an arylene group that may have a substituent, or a heterocyclic group that may have a substituent; or a hydrogen atom of the alkyl group may be substituted by a fluorine atom), or a substituted or unsubstituted aryl group which has one or two rings (one or more CH groups of the aryl group may be substituted by an N atom);
$R_{10}$ group represents a hydrogen atom, a substituted or unsubstituted alkyl group, a substituted or unsubstituted aralkyl group, a substituted or unsubstituted aryl group, a substituted or unsubstituted heterocyclic group, a

substituted amino group, or a halogen atom;

e represents an integer of 1 to 9, and when a plurality of $R_{10}$ groups are present, the plurality of $R_{10}$ groups may be the same or different; and

m represents an integer of 2 to 10, and the plurality of fluorenediyl groups may be the same or different.

**5.** An organic light-emitting device according to claim 2, wherein the second compound is represented by the following general formula (3):

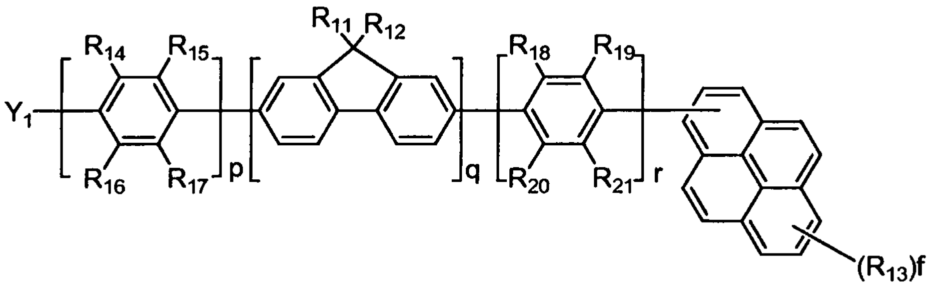

(3)

wherein $R_{11}$, $R_{12}$, and $R_{14}$ to $R_{21}$ groups each represent a hydrogen atom, a substituted or unsubstituted alkyl group, a substituted or unsubstituted aralkyl group, a substituted or unsubstituted aryl group, or a substituted or unsubstituted heterocyclic group; and $R_{11}$ and $R_{12}$ groups may be the same or different;

$Y_1$ group represents a hydrogen atom or a substituted or unsubstituted fused ring structure composed of hydrocarbon;

q represents an integer of 1 to 10, and when q represents 2 or more, a plurality of fluorenediyl groups may be the same or different;

p means a number of a repeating structure of a substituted or unsubstituted phenyl group, and represents zero or an integer of 1 to 20, and;

r means a number of a repeating structure of a substituted or unsubstituted phenyl group, and represents an integer of 1 to 20; and

$R_{13}$ group represents a hydrogen atom, a substituted or unsubstituted alkyl group, a substituted or unsubstituted aralkyl group, a substituted or unsubstituted aryl group, a substituted or unsubstituted heterocyclic group, a substituted amino group, or a halogen atom, f represents an integer of 1 to 9, and when a plurality of $R_{13}$ groups are present, the plurality of $R_{13}$ groups may be the same or different.

**6.** An organic light-emitting device according to claim 1, wherein the first compound and the second compound are each constituted of only carbon and hydrogen.

**7.** An organic light-emitting device according to claim 1, wherein the first compound has the fluoranthene skeleton and a fluorene skeleton.

**8.** An organic light-emitting device according to claim 1, comprising the light-emitting layer including the light-emitting region, a hole transport layer in contact with an anode side of the light-emitting layer, and an electron transport layer in contact with a cathode side of the light-emitting layer,
wherein an energy gap of an electron transport material constituting the electron transport layer is larger than 3.00 eV, and an energy gap of a hole transport material constituting the hole transport layer is larger than 3.15 eV.

**9.** An organic blue-light-emitting device according to claim 1, wherein the electron mobility $\mu H$ of the second compound is $1 \times 10^{-4}$ $cm^2/Vs$ or more.

**10.** An organic blue-light-emitting device according to claim 1,
wherein an electron mobility $\mu E$ of the light-emitting layer and the electron mobility $\mu H$ of the second compound satisfy a relationship of $\mu E/\mu H \leq 0.1$.

**11.** A full-color display comprising:

a blue light-emitting pixel including the organic blue-light-emitting device according to any one of claims 1 to 9;

a red light-emitting pixel;
a green light-emitting pixel; and
a two-dimensionally arranged array of TFT.

## Patentansprüche

**1.** Organische, blaues Licht emittierende Vorrichtung, die umfasst:

ein Elektrodenpaar, das aus einer Anode und einer Kathode aufgebaut ist; und
eine Schicht, die aus einer organischen Verbindung aufgebaut ist und zwischen dem Elektrodenpaar gelagert ist, wobei die Schicht einen Licht emittierenden Bereich aufweist und eine erste Verbindung, die ein Fluoranthengrundgerüst beinhaltet, und eine zweite Verbindung, die ein Pyrengrundgerüst beinhaltet, enthält;
die zweite Verbindung weist eine Energielücke auf, die größer als eine Energielücke der ersten Verbindung ist; und
eine niedrigstes unbesetztes Molekülorbital-Energie EL1 der ersten Verbindung und eine niedrigstes unbesetztes Molekülorbital-Energie EL2 der zweiten Verbindung erfüllen eine Beziehung von $EL2 - EL1 \geq 0{,}15$ eV, und
eine höchstes unbesetztes Molekülorbital-Energie EH1 der ersten Verbindung und eine höchstes unbesetztes Molekülorbital-Energie EH2 der zweiten Verbindung erfüllen eine Beziehung von $EH2 - EH1 > 0$ eV,
wobei die zweite Verbindung ein Wirtmaterial ist und die erste Verbindung ein lumineszentes Dotierungsmaterial ist,
wobei die Elektronenmobilität des Wirtmaterials größer ist als die Lochmobilität des Wirtmaterials, und
die Energielücken und die Molekülorbitalenergien durch die in der Beschreibung beschriebenen Verfahren bestimmt sind.

**2.** Organische, Licht emittierende Vorrichtung nach Anspruch 1, wobei die zweite Verbindung das Pyrengrundgerüst und ein Fluorengrundgerüst aufweist.

**3.** Organische, Licht emittierende Vorrichtung nach Anspruch 2, wobei die zweite Verbindung durch die folgende allgemeine Formel (1) dargestellt ist:

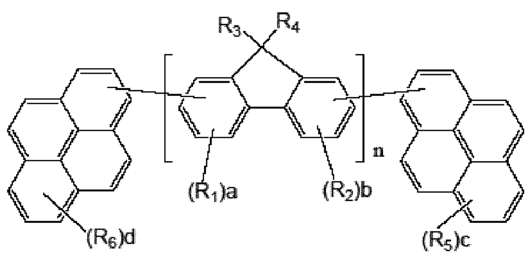

(1)

wobei $R_1$ und $R_2$ Gruppen jeweils ein Wasserstoffatom, eine substituierte oder unsubstituierte Alkylgruppe, eine substituierte oder unsubstituierte Aralkylgruppe, eine substituierte oder unsubstituierte Arylgruppe, eine substituierte oder unsubstituierte heterozyklische Gruppe, eine substituierte Aminogruppe, eine Cyanogruppe oder ein Halogenatom darstellen; $R_1$ Gruppen, die an unterschiedliche Fluorendiylgruppen gebunden sind, gleich oder unterschiedlich sein können, und $R_2$ Gruppen, die an unterschiedliche Fluorendiylgruppen gebunden sind, gleich oder unterschiedlich sein können; und $R_1$ Gruppen, die an die selbe Fluorendiylgruppe gebunden sind, gleich oder unterschiedlich sein können, $R_2$ Gruppen, die an die selbe Fluorendiylgruppe gebunden sind, gleich oder unterschiedlich sein können, und $R_1$ und $R_2$ Gruppen, die an die selbe Fluorendiylgruppe gebunden sind, gleich oder unterschiedlich voneinander sein können;
$R_3$ und $R_4$ Gruppen jeweils ein Wasserstoffatom, eine substituierte oder unsubstituierte Alkylgruppe, eine substituierte oder unsubstituierte Aralkylgruppe, eine substituierte oder unsubstituierte Arylgruppe oder eine substituierte oder unsubstituierte heterozyklische Gruppe darstellen; $R_3$ Gruppen, die an unterschiedliche Fluorendiylgruppen gebunden sind, gleich oder unterschiedlich sein können, und $R_4$ Gruppen, die an unterschiedliche Fluorendiylgruppen gebunden sind, gleich oder unterschiedlich sein können; und $R_3$ und $R_4$ Gruppen, die an

die selbe Fluorendiylgruppe gebunden sind, gleich oder unterschiedlich voneinander sein können;
$R_5$ und $R_6$ Gruppen jeweils ein Wasserstoffatom, eine substituierte oder unsubstituierte Alkylgruppe, eine substituierte oder unsubstituierte Aralkylgruppe, eine substituierte oder unsubstituierte Arylgruppe, eine substituierte oder unsubstituierte heterozyklische Gruppe, eine substituierte Aminogruppe, eine Cyanogruppe oder ein Halogenatom darstellen; $R_5$ Gruppen gleich oder unterschiedlich sein können, $R_6$ Gruppen gleich oder unterschiedlich sein können, und $R_5$ und $R_6$ Gruppen gleich oder unterschiedlich voneinander sein können; und
a und b jeweils eine ganze Zahl von 1 bis 3 darstellen und gleich oder unterschiedlich voneinander sein können,
c und d jeweils eine ganze Zahl von 1 bis 9 darstellen und gleich oder unterschiedlich voneinander sein können,
und n eine ganze Zahl von 1 bis 10 darstellt.

**4.** Organische, Licht emittierende Vorrichtung nach Anspruch 2, wobei die zweite Verbindung durch die folgende allgemeine Formel (2) dargestellt ist:

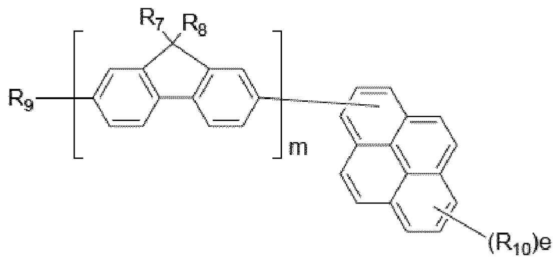

(2)

wobei $R_7$ und $R_8$ Gruppen jeweils ein Wasserstoffatom, eine substituierte oder unsubstituierte Alkylgruppe, eine substituierte oder unsubstituierte Aralkylgruppe, eine substituierte oder unsubstituierte Arylgruppe oder eine substituierte oder unsubstituierte heterozyklische Gruppe darstellen; und $R_7$ und $R_8$ Gruppen gleich oder unterschiedlich sein können;
$R_9$ Gruppe ein Halogenatom, eine lineare, verzweigte oder zyklische Alkylgruppe (wobei eine oder mehrere Methylengruppen der Alkylgruppe durch -O-, -S-, -CO-, -CO-O-, -O-CO-, -CH=CH-, -C≡C-, eine Arylengruppe, die einen Substituenten aufweisen kann, oder eine heterozyklische Gruppe, die einen Substituenten aufweisen kann, substituiert sein kann; oder ein Wasserstoffatom der Alkylgruppe durch ein Fluoratom substituiert sein kann), oder eine substituierte oder unsubstituierte Arylgruppe, welche einen oder zwei Ringe aufweist (eine oder mehrere der CH Gruppen der Arylgruppe kann durch ein N Atom substituiert sein) darstellt;
$R_{10}$ Gruppe ein Wasserstoffatom, eine substituierte oder unsubstituierte Alkylgruppe, eine substituierte oder unsubstituierte Aralkylgruppe, eine substituierte oder unsubstituierte Arylgruppe, eine substituierte oder unsubstituierte heterozyklische Gruppe, eine substituierte Aminogruppe oder ein Halogenatom darstellt;
e eine ganze Zahl von 1 bis 9 darstellt, und, wenn eine Mehrzahl von $R_{10}$ Gruppen vorhanden ist, die Mehrzahl von $R_{10}$ Gruppen gleich oder unterschiedlich sein können; und
m eine ganze Zahl von 2 bis 10 darstellt, und die Mehrzahl von Fluorendiylgruppen gleich oder unterschiedlich sein können.

**5.** Organische, Licht emittierende Vorrichtung nach Anspruch 2, wobei die zweite Verbindung durch die folgende allgemeine Formel (3) dargestellt ist:

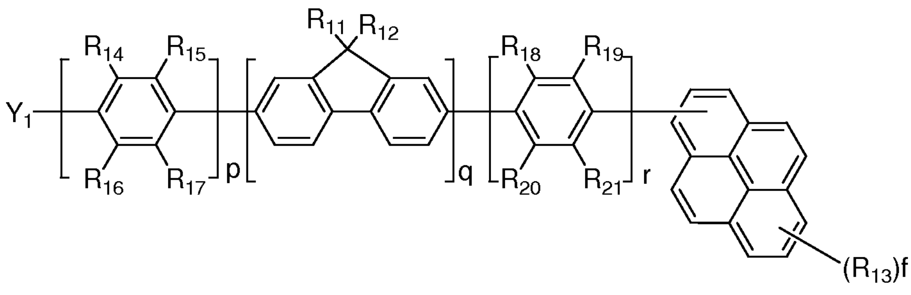

(3)

wobei $R_{11}$, $R_{12}$ und $R_{14}$ bis $R_{21}$ Gruppen jeweils ein Wasserstoffatom, eine substituierte oder unsubstituierte Alkylgruppe, eine substituierte oder unsubstituierte Aralkylgruppe, eine substituierte oder unsubstituierte Arylgruppe oder eine substituierte oder unsubstituierte heterozyklische Gruppe darstellen; und $R_{11}$ und $R_{12}$ Gruppen gleich oder unterschiedlich sein können;
$Y_1$ Gruppe ein Wasserstoffatom oder eine substituierte oder unsubstituierte kondensierte Ringstruktur, die aus Kohlenwasserstoff aufgebaut ist, darstellt;
q eine ganze Zahl von 1 bis 10 darstellt, und wenn q 2 oder mehr darstellt, eine Mehrzahl von Fluorendiylgruppen gleich oder unterschiedlich sein können;
p eine Anzahl einer Wiederholungsstruktur einer substituierten oder unsubstituierten Phenylgruppe bedeutet und Null oder eine ganze Zahl von 1 bis 20 darstellt, und;
r eine Anzahl einer Wiederholungsstruktur einer substituierten oder unsubstituierten Phenylgruppe bedeutet und eine ganze Zahl von 1 bis 20 darstellt; und
$R_{13}$ Gruppe ein Wasserstoffatom, eine substituierte oder unsubstituierte Alkylgruppe, eine substituierte oder unsubstituierte Aralkylgruppe, eine substituierte oder unsubstituierte Arylgruppe, eine substituierte oder unsubstituierte heterozyklische Gruppe, eine substituierte Aminogruppe oder ein Halogenatom darstellt, f eine ganze Zahl von 1 bis 9 darstellt, und wenn eine Mehrzahl von $R_{13}$ Gruppen vorhanden ist, die Mehrzahl von $R_{13}$ Gruppen gleich oder unterschiedlich sein können.

**6.** Organische, Licht emittierende Vorrichtung nach Anspruch 1, wobei die erste Verbindung und die zweite Verbindung jeweils aus lediglich Kohlenstoff und Wasserstoff aufgebaut sind.

**7.** Organische, Licht emittierende Vorrichtung nach Anspruch 1, wobei die erste Verbindung das Fluoranthengrundgerüst und ein Fluorengrundgerüst aufweist.

**8.** Organische, Licht emittierende Vorrichtung nach Anspruch 1, die eine Licht emittierende Schicht, die einen Licht emittierenden Bereich beinhaltet, eine Lochtransportschicht, die in Kontakt mit einer Anodenseite der Licht emittierenden Schicht steht, und eine Elektronentransportschicht, die in Kontakt mit der Kathodenseite der Licht emittierenden Schicht steht, umfasst,
wobei eine Energielücke des Elektronentransportmaterials, das die Elektronentransportschicht aufbaut, größer als 3,00 eV ist, und eine Energielücke eines Lochtransportmaterials, das die Lochtransportschicht aufbaut, größer als 3,15 eV ist.

**9.** Organische, blaues Licht emittierende Vorrichtung nach Anspruch 1, wobei die Elektronenmobilität $\mu H$ der zweiten Verbindung $1 \times 10^{-4}$ $cm^2/Vs$ oder mehr beträgt.

**10.** Organische, blaues Licht emittierende Vorrichtung nach Anspruch 1, wobei eine Elektronenmobilität $\mu E$ der Licht emittierenden Schicht und die Elektronenmobilität $\mu H$ der zweiten Verbindung eine Beziehung von $\mu E/\mu H \leq 0{,}1$ erfüllen.

**11.** Vollfarbanzeige, die umfasst:

einen blaues Licht emittierenden Bildpunkt, der die organische, blaues Licht emittierende Vorrichtung nach einem der Ansprüche 1 bis 9 umfasst;
einen rotes Licht emittierenden Bildpunkt;
einen grünes Licht emittierenden Bildpunkt; und
einen zweidimensional angeordneten TFT Array.

## Revendications

**1.** Dispositif organique à électroluminescence bleue, comprenant :

une paire d'électrodes constituées d'une anode et d'une cathode ; et
une couche constituée d'un composé organique et interposée entre les deux électrodes,
dans lequel la couche possède une région électroluminescente et contient un premier composé comprenant un squelette fluoranthène et un second composé comprenant un squelette pyrène ;
le second composé a un intervalle d'énergie supérieur à un intervalle d'énergie du premier composé ; et
l'énergie d'orbitale moléculaire non occupée la plus basse EL1 du premier composé et l'énergie d'orbitale

moléculaire non occupée la plus basse EL2 du second composé satisfont la relation EL2 - EL1 ≥ 0,15 eV, et l'énergie d'orbitale moléculaire occupée la plus élevée EH1 du premier composé et l'énergie d'orbitale moléculaire occupée la plus élevée EH2 du second composé satisfont la relation EH2 - EH1 > 0 eV,
dans lequel le second composé est une matière incluante et le premier composé est une matière dopante luminescente,
dans lequel la mobilité électronique de la matière incluante est supérieure à la mobilité de lacunes de la matière incluante, et
les intervalles d'énergie et les énergies d'orbitales moléculaires étant déterminés par les procédés décrits dans la description.

**2.** Dispositif électroluminescent organique suivant la revendication 1, dans lequel le second composé possède le squelette pyrène et un squelette fluorène.

**3.** Dispositif électroluminescent organique suivant la revendication 2, dans lequel le second composé est représenté par la formule générale (1) suivante :

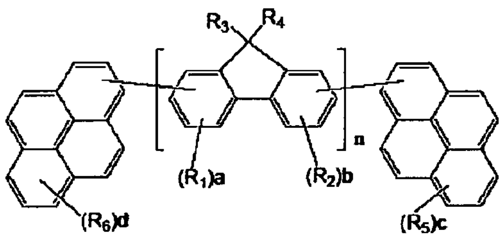

(1)

dans laquelle les groupes $R_1$ et $R_2$ représentent chacun un atome d'hydrogène, un groupe alkyle substitué ou non substitué, un groupe aralkyle substitué ou non substitué, un groupe aryle substitué ou non substitué, un groupe hétérocyclique substitué ou non substitué, un groupe amino substitué, un groupe cyano ou un atome d'halogène ; les groupes $R_1$ liés à des groupes fluorènediyle différents peuvent être identiques ou différents, et les groupes $R_2$ liés à des groupes fluorènediyle différents peuvent être identiques ou différents ; et les groupes $R_1$ liés au même groupe fluorènediyle peuvent être identiques ou différents, les groupes $R_2$ liés au même groupe fluorènediyle peuvent être identiques ou différents, et les groupes $R_1$ et $R_2$ liés au même groupe fluorènediyle peuvent être identiques ou différents les uns des autres ;
les groupes $R_3$ et $R_4$ représentent chacun un atome d'hydrogène, un groupe alkyle substitué ou non substitué, un groupe aralkyle substitué ou non substitué, un groupe aryle substitué ou non substitué ou un groupe hétérocyclique substitué ou non substitué ; les groupes $R_3$ liés à des groupes fluorènediyle différents peuvent être identiques ou différents, et les groupes $R_4$ liés à des groupes fluorènediyle différents peuvent être identiques ou différents, et les groupes $R_3$ et $R_4$ liés au même groupe fluorènediyle peuvent être identiques ou différents les uns des autres ;
les groupes $R_5$ et $R_6$ représentent chacun un atome d'hydrogène, un groupe alkyle substitué ou non substitué, un groupe aralkyle substitué ou non substitué, un groupe aryle substitué ou non substitué, un groupe hétérocyclique substitué ou non substitué, un groupe amino substitué, un groupe cyano ou un atome d'halogène ; les groupes $R_5$ peuvent être identiques ou différents, les groupes $R_6$ peuvent être identiques ou différents, et les groupes $R_5$ et $R_6$ peuvent être identiques ou différents les uns des autres ; et
a et b représentent chacun un nombre entier de 1 à 3 et peuvent être identiques ou différents les uns des autres, c et d représentent chacun un nombre entier de 1 à 9 et peuvent être identiques ou différents les uns des autres, et n représente un nombre entier de 1 à 10.

**4.** Dispositif électroluminescent organique suivant la revendication 2, dans lequel le second composé est représenté par la formule générale (2) suivante :

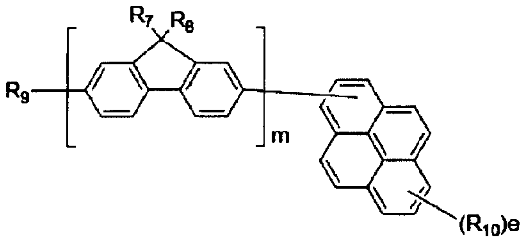

(2)

dans laquelle les groupes $R_7$ et $R_8$ représentent chacun un atome d'hydrogène, un groupe alkyle substitué ou non substitué, un groupe aralkyle substitué ou non substitué, un groupe aryle substitué ou non substitué ou un groupe hétérocyclique substitué ou non substitué ; et les groupes $R_7$ et $R_8$ peuvent être identiques ou différents ;
le groupe $R_9$ représente un atome d'hydrogène, un groupe alkyle linéaire, ramifié ou cyclique (un ou plusieurs groupes méthylène du groupe alkyle peuvent être substitués par un groupe O-, -S-, -CO-, -CO-O-, -O-CO-, -CH=CH-, C≡C-, un groupe arylène qui peut porter un substituant, ou un groupe hétérocyclique qui peut porter un substituant ; ou un atome d'hydrogène du groupe alkyle peut être substitué par un atome de fluor), ou un groupe aryle substitué ou non substitué qui possède un ou deux noyaux (un ou plusieurs groupes CH du groupe aryle peuvent être substitués par un atome de N) ;
le groupe $R_{10}$ représente un atome d'hydrogène, un groupe alkyle substitué ou non substitué, un groupe aralkyle substitué ou non substitué, un groupe aryle substitué ou non substitué, un groupe hétérocyclique substitué ou non substitué, un groupe amino substitué ou un atome d'halogène ;
e représente un nombre entier de 1 à 9 et, lorsqu'une pluralité de groupes $R_{10}$ est présente, les groupes $R_{10}$ peuvent être identiques ou différents ; et
m représente un nombre entier de 2 à 10, et les groupes fluorènediyle peuvent être identiques ou différents.

**5.** Dispositif électroluminescent organique suivant la revendication 2, dans lequel le second composé est représenté par la formule générale (3) suivante :

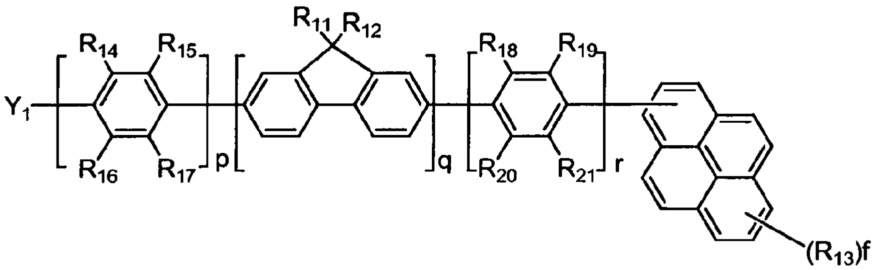

(3)

dans laquelle les groupes $R_{11}$, $R_{12}$ et $R_{14}$ à $R_{21}$ représentent chacun un atome d'hydrogène, un groupe alkyle substitué ou non substitué, un groupe aralkyle substitué ou non substitué, un groupe aryle substitué ou non substitué ou un groupe hétérocyclique substitué ou non substitué ; et
le groupe $Y_1$ représente un atome d'hydrogène ou une structure cyclique condensée substituée ou non substituée constituée de carbone et d'hydrogène ;
q représente un nombre entier de 1 à 10 et, lorsque q est égal ou supérieur à 2, les groupes fluorènediyle peuvent être identiques ou différents ;
p représente un nombre d'une structure répétée constituée d'un groupe phényle substitué ou non substitué et est égal à zéro ou à un nombre de 1 à 20 ; et
r représente un nombre d'une structure répétée constituée d'un groupe phényle substitué ou non substitué et représente un nombre de 1 à 20 ; et
le groupe $R_{13}$ représente un atome d'hydrogène, un groupe alkyle substitué ou non substitué, un groupe aralkyle substitué ou non substitué, un groupe aryle substitué ou non substitué, un groupe hétérocyclique substitué ou non substitué, un groupe amino substitué ou un atome d'halogène, f représente un nombre entier de 1 à 9 et, lorsque qu'une pluralité de groupes $R_{13}$ est présente, les groupes $R_{13}$ peuvent être identiques ou différents.

**6.** Dispositif électroluminescent organique suivant la revendication 1, dans lequel le premier composé et le second

composé sont constitués chacun seulement de carbone et d'hydrogène.

**7.** Dispositif électroluminescent organique suivant la revendication 1, dans lequel le premier composé possède le squelette fluoranthène et un squelette fluorène.

**8.** Dispositif électroluminescent organique suivant la revendication 1, comprenant la couche électroluminescente comprenant la région électroluminescente, une couche de transport de lacunes en contact avec la face tournée vers l'anode de la couche électroluminescente, et une couche de transport d'électrons en contact avec la face tournée vers la cathode de la couche électroluminescente,
dans lequel l'intervalle d'énergie d'une matière de transport d'électrons constituant la couche de transport d'électrons est supérieur à 3,00 eV, et l'intervalle d'énergie d'une matière de transport de lacunes constituant la couche de transport de lacunes est supérieure à 3,15 eV.

**9.** Dispositif organique à électroluminescence bleue suivant la revendication 1, dans lequel la mobilité électronique $\mu H$ du second composé est égale ou supérieure à $1 \times 10^{-4}$ $cm^2/Vs$.

**10.** Dispositif organique à électroluminescence bleue suivant la revendication 1, dans lequel la mobilité électronique $\mu E$ de la couche électroluminescente et la mobilité électronique $\mu H$ du second composé satisfont la relation $\mu E/\mu H < 0,1$.

**11.** Système d'affichage en couleurs intégrales comprenant :

un pixel électroluminescent bleu comprenant le dispositif organique à électroluminescence bleue suivant l'une quelconque des revendications 1 à 9 ;
un pixel électroluminescent rouge ;
un pixel électroluminescent vert ; et
un réseau de TFT à disposition bidimensionnelle.

FIG. 1

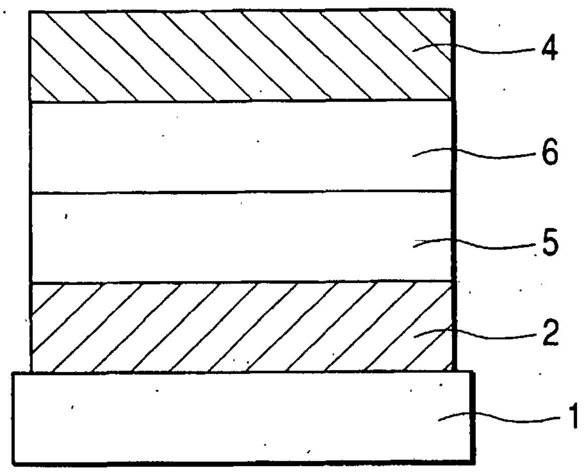


FIG. 2

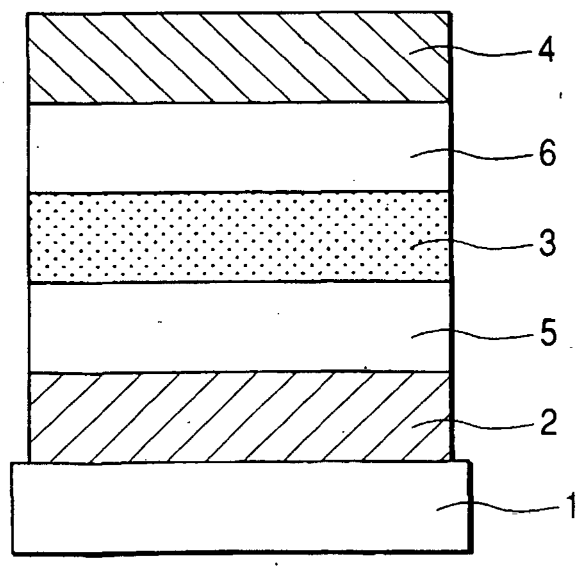

FIG. 3

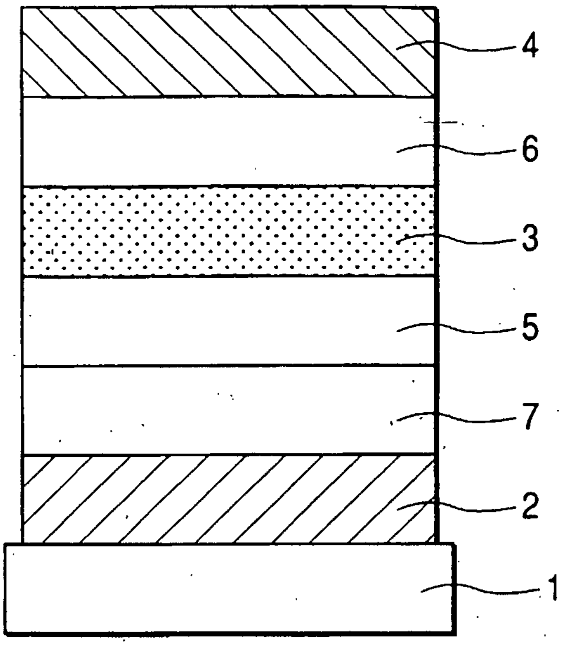


FIG. 4

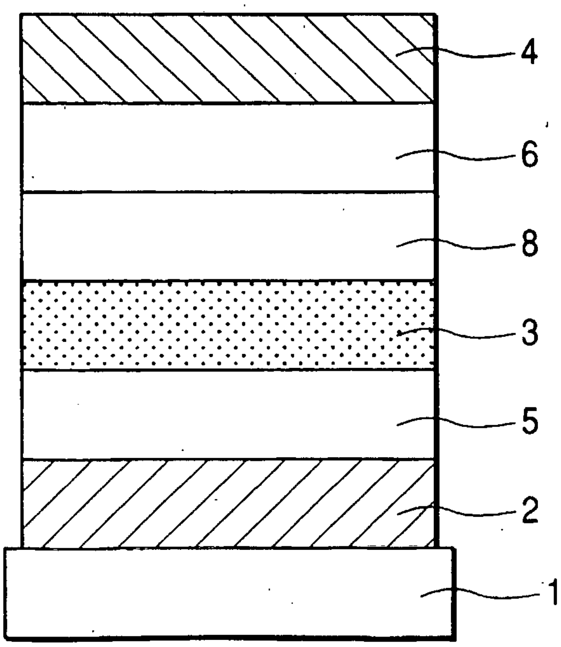

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005108726 A
- JP H10189248 B
- WO 2005081587 A1
- EP 1565041 A1

### Non-patent literature cited in the description

- *Appl. Phys. Lett.,* 1987, vol. 51, 913
- *Appl. Phys. Lett.,* 1999, vol. 75, 4
- *SOGIETY FOR INFORMATION DISPLAY 2003 INTERNATIONAL SYMPOSIUM, DIGEST OF TECHNICAL PAPERS,* 2003, vol. 45 (3), 1294